# EUROPEAN PATENT APPLICATION

(11) **EP 4 687 405 A1**
(43) Date of publication of application: **04.02.2026**
(21) Application number: 25185804.9
(22) Date of filing: 27.06.2025
(51) Int. Cl.: H10K 59/121, H10K 59/131, H10K 59/123, H10K 59/65

(54) **ELECTRONIC DEVICE**

(30) Priority: 29.07.2024 KR 20240099977
(71) Applicant: Samsung Display Co., Ltd., Yongin-si, Gyeonggi-do 17113 (KR)
(72) Inventor: NAM, Donghun, Giheung-Gu, Yongin-si, Gyeonggi-Do (KR); KIM, Kiyoung, Giheung-Gu, Yongin-si, Gyeonggi-Do (KR); KIM, Eunhye, Giheung-gu, Yongin-si, Gyeonggi-do (KR); PARK, Jiyun, Giheung-Gu, Yongin-si, Gyeonggi-Do (KR); LEE, Sola, Giheung-Gu, Yongin-si, Gyeonggi-Do (KR); SON, Donghyun, Giheung-gu, Yongin-si, Gyeonggi-do (KR)
(74) Representative: Dr. Weitzel & Partner

(57) **Abstract**

An electronic device includes a display panel and an electronic module. The display panel includes a first region and a second region, and the first region includes a first sub-region and a second sub-region having light transmittance lower than light transmittance of the first sub-region. The electronic module is under the display panel corresponding to the first region, The display panel includes first light emitting elements in the first sub-region, first pixel circuits connected to the first light emitting elements, and located in the second sub-region, second light emitting elements in the second sub-region, second pixel circuits connected to the second light emitting elements, and located in the second sub-region, and connecting lines connecting first light emitting elements and first pixel circuits.

## Description

The present invention relates to an electronic device.

An electronic device may be a device including various electronic components such as a display panel, and an electronic module. The electronic module may include a camera, an infrared detection sensor, and/or a proximity sensor. The electronic module may be disposed under the display panel. The transmittance of a partial region of the display panel may be higher than that of another partial region of the display panel. The electronic module may receive an external input through the partial region of the display panel, or may provide an output through the partial region of the display panel.

The present invention provides an electronic device improved in productivity and in the performance of an electronic module. The present invention is defined by the independent claims. The dependent claims and the description provide preferred embodiments.

According to one or more embodiments of the present invention, an electronic device includes a display panel including a first region and a second region adjacent to the first region, in which the first region includes a first sub-region and a second sub-region having light transmittance lower than light transmittance of the first sub-region, and an electronic module under the display panel to correspond to the first region.

The display panel includes first light emitting elements in the first sub-region, first pixel circuits connected to the first light emitting elements, and in the second sub-region, second light emitting elements in the second sub-region, second pixel circuits connected to the second light emitting elements, and in the second sub-region, and connecting lines connecting the first light emitting elements and the first pixel circuits.

The connecting lines include first connecting lines on a first layer and second connecting lines on a second layer covering the first connecting lines. The first connecting lines have a length different from a length of the second connecting lines.

According to one or more embodiments of the present invention, an electronic device includes a display panel including a first region and a second region adjacent to the first region, in which the first region includes a first sub-region and a second sub-region having light transmittance lower than light transmittance of the first sub-region, and an electronic module under the display panel corresponding to the first region.

The display panel includes first light emitting elements in the first sub-region, first pixel circuits connected to the first light emitting elements, and located in the second sub-region, second light emitting elements in the second sub-region, second pixel circuits connected to the second light emitting elements, and in the second sub-region, and connecting lines connecting the first light emitting elements and the first pixel circuits.

The connecting lines includes first connecting lines extending from the second sub-region to the first sub-region, and second connecting lines from the second sub-region to the first sub-region through the second region.

The above and other aspects and features of the present invention will become apparent by describing in detail embodiments thereof with reference to the accompanying drawings.
FIG. 1 is a perspective view of an electronic device according to one or more embodiments of the present invention.
FIG. 2 is an exploded perspective view illustrating some components of an electronic device according to one or more embodiments of the present invention.
FIG. 3 is a cross-sectional view illustrating a display module according to one or more embodiments of the present invention.
FIG. 4 is a plan view of a display panel according to one or more embodiments of the present invention.
FIG. 5 is a circuit diagram of a pixel according to one or more embodiments of the present invention.
FIG. 6A is a plan view illustrating a display panel according to one or more embodiments of the present invention.
FIG. 6B is an enlarged view obtained by enlarging a partial region of a display panel illustrated in FIG. 6A.
FIG. 7 is a view illustrating an arrangement structure of connecting lines according to one or more embodiments of the present invention.
FIG. 8 is a block diagram illustrating the arrangement of first to third connecting lines according to one or more embodiments of the present invention.
FIGS. 9A and 9B are views illustrating cross-sectional structures of a first region and a second region of a display panel according to one or more embodiments of the present invention.
FIG. 10 is a block diagram illustrating the arrangement of the first to third connecting lines according to one or more embodiments of the present invention.
FIGS. 11A and 11B are views illustrating cross-sectional structures of a first region and a second region of a display panel according to one or more embodiments of the present invention.
FIG. 12 is a block diagram illustrating the lengths of the first to third connecting lines according to one or more embodiments of the present invention.
FIGS. 13A and 13B are cross-sectional views illustrating the first and second connecting lines according to one or more embodiments of the present invention.
FIG. 14 is a view illustrating the shape of the first region and the arrangement structure of the connecting lines resulting from the shape according to one or more embodiments of the present invention.
FIG. 15 is a view illustrating the shape of the first region and the arrangement structure of the connecting lines resulting from the shape according to one or more embodiments of the present invention.
FIG. 16 is a view illustrating the shape of the first region and the arrangement structure of the connecting lines resulting from the shape according to one or more embodiments of the present invention.

### DETAILED DESCRIPTION

In the specification, the expression that a first component (or region, layer, or part) is "on", "connected to", or "coupled to" a second component refers to that the first component is directly on, connected to, or coupled to the second component or refers to that a third component is interposed therebetween.

The same reference numeral will be assigned to the same component. In addition, in drawings, thicknesses, proportions, and dimensions of components may be exaggerated to describe the technical features effectively. The term "and/or" includes any and all combinations of one or more of associated components

Although the terms "first", or "second" may be used to describe various components, the components should not be construed as being limited by the terms. The terms are only used to distinguish one component from another component. For example, a first component may be referred to as a second component, and similarly, the second component may be referred to as the first component. The singular forms are intended to include the plural forms unless the context clearly indicates otherwise.

In addition, the terms "under", "at a lower portion", "above", "an upper portion" are used to describe the relationship between components illustrated in drawings. The terms are relative and will be described with reference to a direction indicated in the drawing.

It will be further understood that the terms "comprise," "include," or "including," or "have" or "having" specify the presence of stated features, numbers, steps, operations, components, parts, or the combination thereof, but do not preclude the presence or addition of one or more other features, numbers, steps, operations, components, and/or the combination thereof.

Unless defined otherwise, all terms (including technical terms and scientific terms) used in the specification have the same meaning as commonly understood by one skilled in the art to which the present invention belongs. Furthermore, terms such as terms defined in the dictionaries commonly used should be interpreted as having a meaning consistent with the meaning in the context of the related technology, and should not be interpreted in ideal or overly formal meanings unless explicitly defined herein.

Further, in this specification, the phrase "on a plane," or "in a plan view," means viewing a target portion from the top, and the phrase "on a cross-section" means viewing a cross-section formed by vertically cutting a target portion from the side.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present invention refers to "one or more embodiments of the present invention".

A person of ordinary skill in the art would appreciate, in view of the present invention in its entirety, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments of the present invention will be described with reference to drawings.

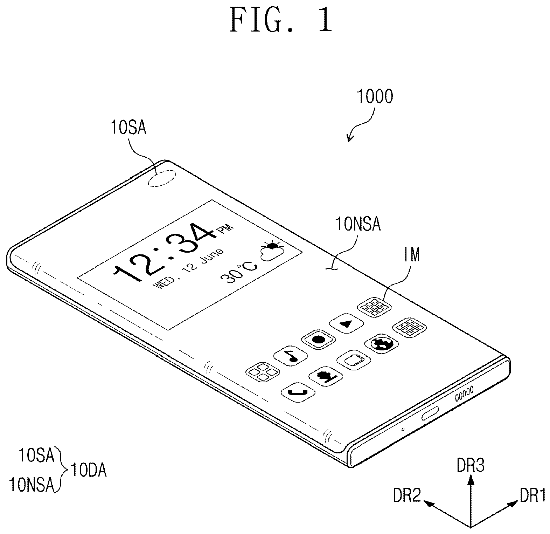

FIG. 1 is a perspective view of an electronic device according to one or more embodiments of the present invention.

Referring to FIG. 1, an electronic device 1000 may be activated, in response to an electrical signal. For example, the electronic device 1000 may be a cellular phone, a tablet, a monitor, a television, an automotive navigation system, a game console, and/or a wearable device. Although FIG. 1 illustrates that the electronic device 1000 is a cellular phone, the present invention is not limited thereto.

The electronic device 1000 may display an image IM through an active region 10DA. The active region 10DA may include a plan defined in a first direction DR1 and a second direction DR2. The active region 10DA may further include curved surfaces bent from at least two sides of the plane. However, the shape of the active region 10DA is not limited thereto. For example, the active region 10DA may include only the plane. Alternatively, the active region 10DA may further include four curved surfaces bent from at least two or more sides of the plane, for example, four sides of the plane.

The active region 10DA may include a first region 10SA (or referred to as a "sensing region") and a second region 10NSA (or referred to as a "non-sensing region"). Although FIG. 1 illustrates one first region 10SA, the number of first regions 10SA is not limited thereto. The first region 10SA may be a portion of the active region 10DA. Accordingly, the electronic device 1000 may display an image through the first region 10SA. The second region 10NSA is disposed to be adjacent to the first region 10SA. According to one or more embodiments of the present invention, the first region 10SA may be surrounded by the second region 10NSA. The first region 10SA may have the transmittance higher than the transmittance of the second region 10NSA. The electronic device 1000 may receive or transmit an optical signal through the first region 10SA.

The electronic device 1000 may include an electronic module disposed in a region overlapped with the first region 10SA. The electronic module may receive an optical signal provided from the outside through the first region 10SA or may output an optical signal through the first region 10SA. For example, the electronic module may refer to a sensor (for example, a camera module or a proximity sensor) that measures a distance between an object and a smartphone, a sensor that recognizes a part (for example, a fingerprint, an iris, or a face) of the user's body, or a small-sized lamp that outputs a light, but the present invention is not limited thereto.

A thickness direction of the electronic device 1000 may be a third direction DR3 being a normal direction of the active region 10DA. Front surfaces (or top surfaces) and rear surfaces (or bottom surfaces) of members constituting the electronic device 1000 may be defined based on the third direction DR3.

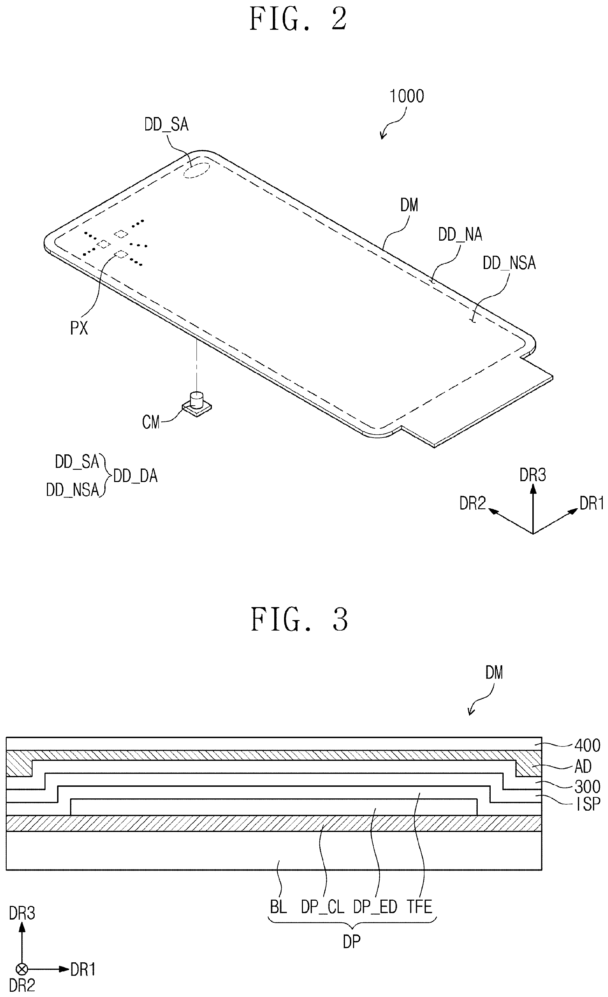

FIG. 2 is an exploded perspective view illustrating some components of an electronic device according to one or more embodiments of the present invention.

Referring to FIG. 2, the electronic device 1000 may include a display device (or a display module) DM and an electronic module CM. The display module DM may generate an image and to sense an input applied from the outside. The electronic module CM is disposed under the display module DM.

The display module DM may include a display region DD_DA and a peripheral region DD_NA. The display region DD_DA may correspond to the active region 10DA illustrated in FIG. 1. The display region DD_DA may include a first region DD_SA and a second region DD_NSA. The first region DD_SA of the display region DD_DA may be defined as a sensing region, and the sensing region DD_SA may have the transmittance higher than that of the second region DD_NSA (hereinafter, referred to as a "non-sensing region (or a "normal region") of the display region DD_DA. Accordingly, the sensing region DD_SA may provide an external natural light to the electronic module CM. Because the sensing region DD_SA is a portion of the display region DD_DA, the sensing region DD_SA may display an image.

Pixels PX are arranged in the display region DD_DA. In other words, the pixel PX is disposed in each of the first region DD_SA and the second region DD_NSA. However, the pixel PX may have different configurations in the first region DD_SA and the second region DD_NSA. Hereinafter, the details thereof will be omitted.

FIG. 3 is a cross-sectional view illustrating a display module according to one or more embodiments of the present invention.

Referring to FIG. 3, the display module DM may include a display panel DP, an input sensor layer ISP, an anti-reflective layer 300, and a window 400. The anti-reflective layer 300 and the window 400 may be coupled to each other through an adhesive layer AD.

The display panel DP may be a component to actually generate an image. The display panel DP may be an emissive-type display panel. For example, the display panel DP may be an organic light emitting display panel, an inorganic light emitting display panel, a micro-LED display panel, or a nano-LED display panel. The display panel DP may be referred to as a display layer.

The display panel DP may include a base layer BL, a circuit layer DP_CL, a light emitting element layer DP_ED, and an encapsulating layer TFE.

The base layer BL may be a member to provide a base surface for disposing the circuit layer DP_CL. The base layer BL may be a rigid substrate, or a flexible substrate allowing bending, folding, and/or rolling. The base layer BL may be a glass substrate, a metal substrate, and/or a polymer substrate. However, the present invention is not limited thereto, and the base layer BL may be an inorganic layer, an organic layer, or a composite material layer.

The base layer BL may have a multi-layer structure. For example, the base layer BL may include a first synthetic resin layer, an inorganic layer of a multi-layer structure or a single layer structure, and a second synthetic resin layer disposed on the inorganic layer. Each of the first and second synthetic resin layers may include polyimide-based resin, but the present invention is not limited thereto.

The circuit layer DP_CL may be disposed on the base layer BL. The circuit layer DP_CL may include an insulating layer, a semiconductor pattern, a conductive pattern, and/or a signal line.

The light emitting element layer DP_ED may be disposed on the circuit layer DP_CL. The light emitting element layer DP_ED may include a light emitting element. For example, the light emitting element may include an organic light emitting material, an inorganic light emitting material, an organic-inorganic light emitting material, a quantum dot, a quantum rod, a micro-LED, and/or a nano-LED.

The encapsulating layer TFE may be disposed on the light emitting element layer DP_ED. The encapsulating layer TFE may protect the light emitting element layer DP_ED from foreign substances such as moisture, oxygen, and/or dust particles. The encapsulating layer TFE may include at least one inorganic layer. The encapsulating layer TFE may include the stack structure of an inorganic layer/organic layer/inorganic layer.

The input sensor layer ISP may be disposed on the display panel DP. The input sensor layer ISP may sense an external input that is applied from the outside. The external input may be a user input. The user input may include various types of external inputs such as a part of a user's body, a light, heat, a pen, and/or pressure.

The input sensor layer ISP may be disposed on the display panel DP through subsequent processes. In this case, the input sensor layer ISP may be directly disposed on the display panel DP (especially, the encapsulating layer TFE). In this case, the wording "being directly disposed" may indicate that a third component (for example, an adhesive member) is not intervened between the input sensor layer ISP and the display panel DP. In other words, a separate adhesive member may not be disposed between the input sensor layer ISP and the display panel DP.

The anti-reflective layer 300 may be directly disposed on the input sensor layer ISP. The anti-reflective layer 300 may reduce the reflectance of an external light incident from the outside of the display module DM. The anti-reflective layer 300 may be formed on the input sensor layer ISP through a successive process. The anti-reflective layer 300 may include color filters. The color filters may have a specific arrangement. For example, the color filters may be arranged in consideration of colors of lights emitted from the pixels included in the display panel DP. In addition, the anti-reflective layer 300 may further include a black matrix adjacent to color filters. The details of the anti-reflective layer 300 will be described in detail later.

According to one or more embodiments of the present invention, the positions of the input sensor layer ISP and the anti-reflective layer 300 may be interchangeable.

According to one or more embodiments of the present invention, the display module DM may further include an optical layer that is disposed on the anti-reflective layer 300. For example, the optical layer may be formed on the anti-reflective layer 300 through subsequent processes. The optical layer may improve the front brightness of the display module DM by controlling a direction of a light incident from the display panel DP. For example, the optical layer may include an organic insulating layer having openings defined to correspond to light emitting regions of pixels included in the display panel DP, and a higher refractive layer filled in the openings while covering the organic insulating layer. The high refractive layer may have a higher refractive index than that of the organic insulating layer.

The window 400 may provide a front surface of the electronic device 1000 (see FIG. 1). The window 400 may include a glass film and/or a synthetic resin film, as a base film. The window 400 may further include an anti-reflective film, and/or an anti-fingerprint film. The window 400 may include a glass film and/or a synthetic resin film. The window 400 may further include a bezel pattern overlapped with the peripheral region DD_NA (see FIG. 2) of the display module DM.

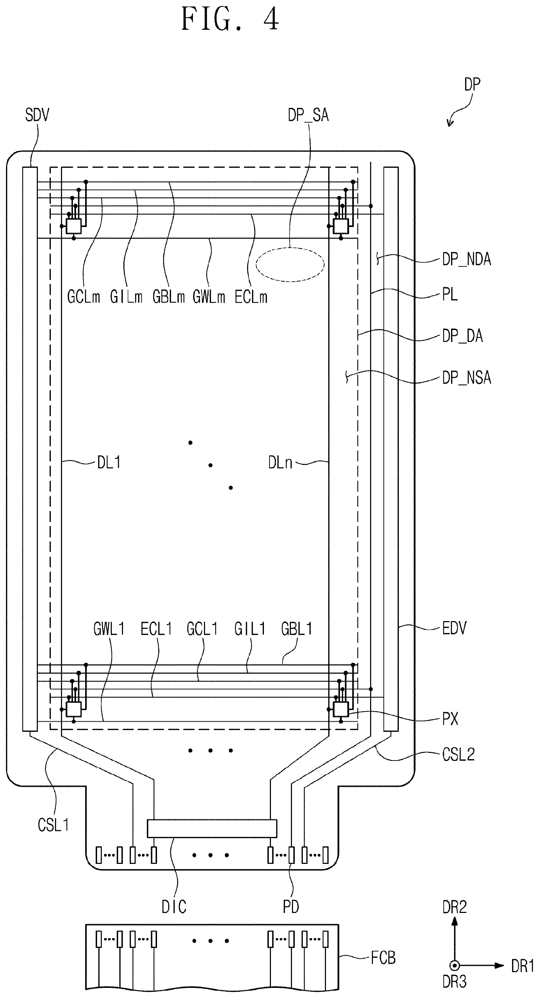

FIG. 4 is a plan view of a display panel according to one or more embodiments of the present invention.

Referring to FIG. 4, the display panel DP may include a display region DP_DA and a non-display region DP_NDA, which is adjacent to the display region DP_DA, defined in the display panel DP. The display region DP_DA and the non-display region DP_NDA may be distinguished therebetween depending on whether the pixel PX is present. The pixel PX is disposed in the display region DP_DA. The non-display region DP-NDA may include a scan driver SDV, a data driver, and a light emitting driver EDV. The data driver may be a partial circuit included in a driving chip DIC.

The display region DP_DA may include a first region DP_SA and a second region DP_NSA. The first region DP_SA may correspond to the first region 10SA illustrated in FIG. 1, and the second region DP_NSA may correspond to the second region 10NSA illustrated in FIG. 1. The first region DP_SA may have the transmittance higher than the transmittance of the second region DP_NSA. The details of the first region DP_SA and the second region DP_NSA will be described later.

The display panel DP includes pixels PX, initializing scan lines GIL1 to GILm, compensating scan lines GCL1 to GCLm, write scan lines GWL1 to GWLm, black scan lines GBL1 to GBLm, light emitting control lines ECL1 to ECLm, data lines DL1 to DLn, first and second control lines CSL1 and CSL2, a driving voltage line PL, and a plurality of pads PD. In this case, "m" and "n" are natural numbers equal to or greater than '2'.

The pixels PX are connected to the initializing scan lines GIL1 to GILm, the compensating scan lines GCL1 to GCLm, the write scan lines GWL1 to GWLm, the black scan lines GBL1 to GBLm, the light emitting control lines ECL1 to ECLm, and data lines DL1 to DLn.

The initializing scan lines GIL1 to GILm, the compensating scan lines GCL1 to GCLm, the write scan lines GWL1 to GWLm, and the black scan lines GBL1 to GBLm may extend in a first direction DR1 and may be electrically connected to the scan driver SDV. The data lines DL1 to DLn may extend in the second direction DR2 and may be electrically connected to the driving chip DIC. The light emitting control lines ECL1 to ECLm may extend in the first direction DR1 to be connected to the light emitting driver EDV.

The driving voltage line PL may include a portion extending in the first direction DR1 and a portion extending in the second direction DR2. The portion extending in the first direction DR1 and the portion extending in the second direction DR2 may be disposed on different layers. The driving voltage line PL may supply a driving voltage to the pixels PX.

The first control line CSL1 may be connected to the scan driver SDV, and the second control line CLS2 may be connected to the light emitting driver EDV.

When viewed in a plan view, the pads PD may be disposed to be adjacent to a lower end of the non-display region DP_NDA. The driving chip DIC, the driving voltage line PL, the first control line CSL1, and the second control line CSL2 may be electrically connected with the pads PD. A flexible circuit board FCB may be electrically connected with the pads PD through an anisotropic conductive adhesive layer.

Although FIG. 4 illustrates that the driving chip DIC is mounted on the non-display region DP_NDA of the display panel DP, the present invention is not limited thereto. For example, the driving chip DIC may be mounted on the flexible circuit board FCB.

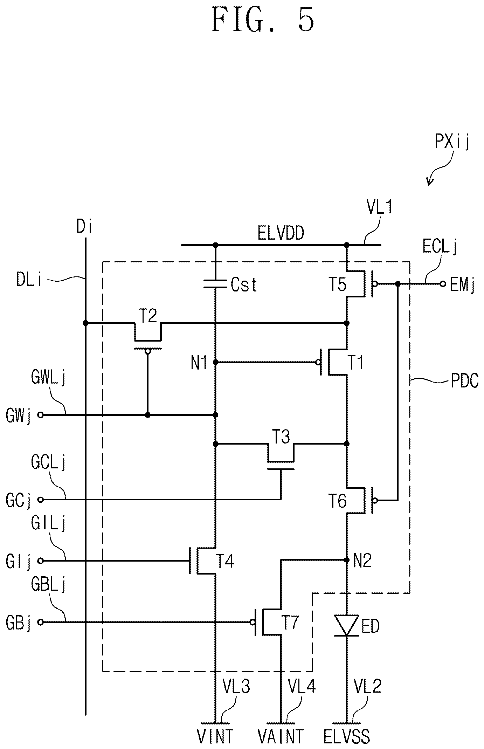

FIG. 5 is a circuit diagram of a pixel PXij according to one or more embodiments of the present invention.

FIG. 5 illustrates an equivalent circuit diagram of one pixel PXij of the plurality of pixels PX (see FIG. 4). Because each of the plurality of pixels PX has the same equivalent circuit structure, the circuit structure of the pixel PXij will be representatively described, and the details of remaining pixels PX will be omitted.

Referring to FIGS. 4 and 5, the pixel PXij may be connected to an i-th data line DLi of the data lines DL1 to DLn, a j-th initializing scan line GILj of the initializing scan lines GIL1 to GILm, a j-th compensating scan line GCLj of the compensating scan lines GCL1 to GCLm, a j-th write scan line GWLj of the write scan lines GWL1 to GWLm, a j-th black scan line GBLj of the black scan lines GBL1 to GBLm, a j-th light emitting control line ECLj of the light emitting control lines ECL1 to ECLm, the first and second driving voltage lines VL1 and VL2, and the first and second initializing voltage lines VL3 and VL4. In this case, 'i' may be an integer ranging from '1' to 'n', and 'j' may be an integer ranging from '1' to 'm'.

The pixel PXij includes a light emitting element ED and a pixel circuit PDC. The light emitting element ED may be a light emitting diode (that is, an LED). According to one or more embodiments of the present invention, the light emitting element ED may be an organic light emitting diode (OLED) including an organic light emitting layer, but the present invention is not limited thereto. The pixel circuit PDC may control an amount of current flowing through the light emitting element ED, to correspond to the data signal Di. The light emitting element ED may emit light having a specific brightness to correspond to an amount of current provided from the pixel circuit PDC.

The pixel circuit PDC includes first to seventh transistors T1, T2, T3, T4, T5, T6, and T7 and at least one capacitor Cst. A configuration of the pixel circuit PDC according to the present invention is not limited to the embodiment illustrated in FIG. 5. The pixel circuit PDC illustrated in FIG. 5 is only an example, and the configuration of the pixel circuit PDC may be modified and implemented.

At least one of the first to seventh transistors T1, T2, T3, T4, T5, T6, and T7 may be a transistor having a low-temperature polycrystalline silicon (LTPS) semiconductor layer. At least one of the first to seventh transistors T1, T2, T3, T4 T5, T6, and T7 may be a transistor having an oxide semiconductor layer. For example, the third and fourth transistors T3 and T4 may be oxide semiconductor transistors, and the first, second, fifth, sixth, and seventh transistors T1, T2, T5, T6, and T7 may be low-temperature polycrystalline silicon (LTPS) transistors.

In detail, the first transistor T1 exerting a direct influence on brightness of the light emitting element ED may be configured to include a semiconductor layer formed of a polycrystalline silicon having higher reliability, and thus, a high-resolution electronic device may be implemented. At least one of a third transistor T3 or a fourth transistor T4 connected to the gate electrode of the first transistor T1 may include an oxide semiconductor to prevent a leakage current flowing into the gate electrode of the first transistor T1.

Some of the first to seventh transistors T1 to T7 may be P-type transistors, and the remaining transistors may be N-type transistors. For example, the first, second, fifth, sixth, and seventh transistors T1, T2, T5, T6, and T7 are P-type transistors, and the third and fourth transistors T3 and T4 may be N-type transistors. However, the present invention is not limited thereto. For example, all of the first to seventh transistors T1 to T7 may be P-type transistors or N-type transistors. Alternatively, the first, second, fifth, and sixth transistors T1, T2, T5, and T6 are P-type transistors, and the third, fourth, and seventh transistors T3, T4, and T7 may be N-type transistors.

The j-th initializing scan line GILj, the j-th compensating scan line GCLj, the j-th write scan line GWLj, the j-th black scan line GBLj, and the j-th light emitting control line ECLj may transmit a j-th initializing scan signal Glj, a j-th compensating scan signal GCj, a j-th write scan signal GWj, a j-th black scan signal GBj, and a j-th light emitting control signal EMj to the pixel PXij, respectively. The i-th data line DLi transmits the i-th data signal Di to the pixel PXij. The data signal Di may have a voltage level corresponding to the image signal input into the electronic device 1000 (see FIG. 1).

The first and second driving voltage lines VL1 and VL2 may transmit a first driving voltage ELVDD and a second driving voltage ELVSS to the pixel PXij, respectively. In addition, the first and second initializing voltage lines VL3 and VL4 may transmit a first initializing voltage VINT and a second initializing voltage VAINT to the pixel PXij. The first and second driving voltage lines VL1 and VL2, and the first and second initializing voltage lines VL3 and VL4 may include the driving voltage line PL illustrated in FIG. 4.

The first transistor T1 is connected between the first driving voltage line VL1 receiving the first driving voltage ELVDD and the light emitting element ED. The first transistor T1 includes a first electrode connected to the first driving voltage line VL1 through the fifth transistor T5, a second electrode connected to a pixel electrode (or an anode electrode) of the light emitting element ED through the sixth transistor T6, and a third electrode (for example, a gate electrode) connected to a first terminal (for example, a first node N1) of the capacitor Cst. The first transistor T1 may receive the i-th data signal Di through the i-th data line DLi depending on a switching operation of the second transistor T2 and then may supply a driving current to the light emitting element ED.

The second transistor T2 is connected between the data line DLi and the first electrode of the first transistor T1. The second transistor T2 includes a first electrode connected to the data line DLi, a second electrode connected to the first electrode of the first transistor T1, and a third electrode (for example, a gate electrode) connected to the j-th write scan line GWLj. The second transistor T2 may be turned on in response to the write scan signal GWj received through the j-th write scan line GWLj to transmit the i-th data signal Di received from the i-th data line DLi to the first electrode of the first transistor T1.

The third transistor T3 is connected between the second electrode of the first transistor T1 and the first node N1. The third transistor T3 may include a first electrode connected to the third electrode of the first transistor T1, a second electrode connected to the second electrode of the first transistor T1, and a third electrode (for example, a gate electrode) connected to the j-th compensating scan line GCLj. The third transistor T3 may be turned on in response to the j-th compensating scan signal GCj received through the j-th compensating scan line GCLj to connect the third electrode of the first transistor T1 and the second electrode of the first transistor T1, such that the first transistor T1 is diode-connected.

The fourth transistor T4 is connected between the first initializing voltage line VL3 for applying the first initializing voltage VINT to the first node N1. The fourth transistor T4 includes a first electrode connected to the first initializing voltage line VL3 for receiving the first initializing voltage VINT, a second electrode connected to the first node N1, and a third electrode (for example, a gate electrode) connected to the j-th initializing scan line GILj. The fourth transistor T4 is turned on in response to the j-th initializing scan signal Glj received through the j-th initializing scan line GILj. The fourth transistor T4 turned on to transmit the first initializing voltage VINT to the first node N1 to initialize a potential (that is, a potential of the first node N1) of the third electrode of the first transistor T1.

The fifth transistor T5 includes a first electrode connected to the first driving voltage line VL1, a second electrode connected to the first electrode of the first transistor T1, and a third electrode (for example, a gate electrode) connected to the j-th light emitting control line ECLj. The sixth transistor T6 may include a first electrode connected to the second electrode of the first transistor T1, a second electrode (for example, a second node N2) connected to the pixel electrode of the light emitting element ED, and a third electrode (for example, a gate electrode) connected to the j-th light emitting control line ECLj.

The fifth and sixth transistors T5 and T6 are concurrently (e.g., simultaneously) turned on in response to the j-th light emitting control signal EMj received through the j-th light emitting control line ECLj. The first driving voltage ELVDD applied through the turned-on fifth transistor T5 may be transmitted to the light emitting element ED through the sixth transistor T6 after compensated through the diode-connected first transistor T1.

The seventh transistor T7 includes a first electrode connected to the second initializing voltage line VL4 for transmitting the second initializing voltage VAINT, a second electrode connected to the second electrode of the sixth transistor T6, and a third electrode (for example, a gate electrode) connected to the j-th black scan line GBLj. The second initializing voltage VAINT may have a voltage level different from a voltage level of the first initializing voltage VINT. For example, the second initializing voltage VAINT may have a voltage level lower than a voltage level of the first initializing voltage VINT.

The first terminal of the capacitor Cst is connected to the third electrode of the first transistor T1, and a second terminal of the capacitor Cst is connected to the first driving voltage line VL1. A cathode of the light emitting element ED may be connected to the second driving voltage line VL2 for transmitting the second driving voltage ELVSS. The voltage level of the second driving voltage ELVSS may be lower than the voltage level of the first driving voltage ELVDD.

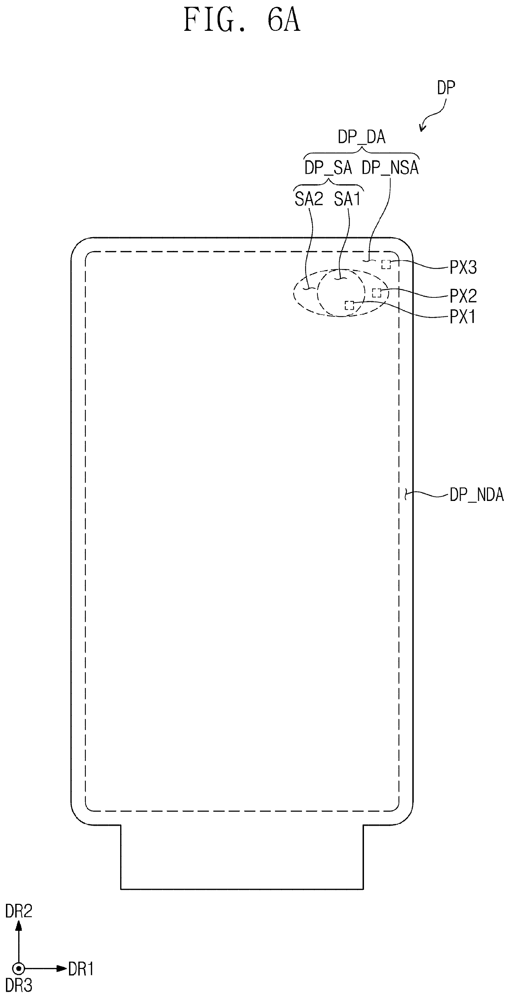

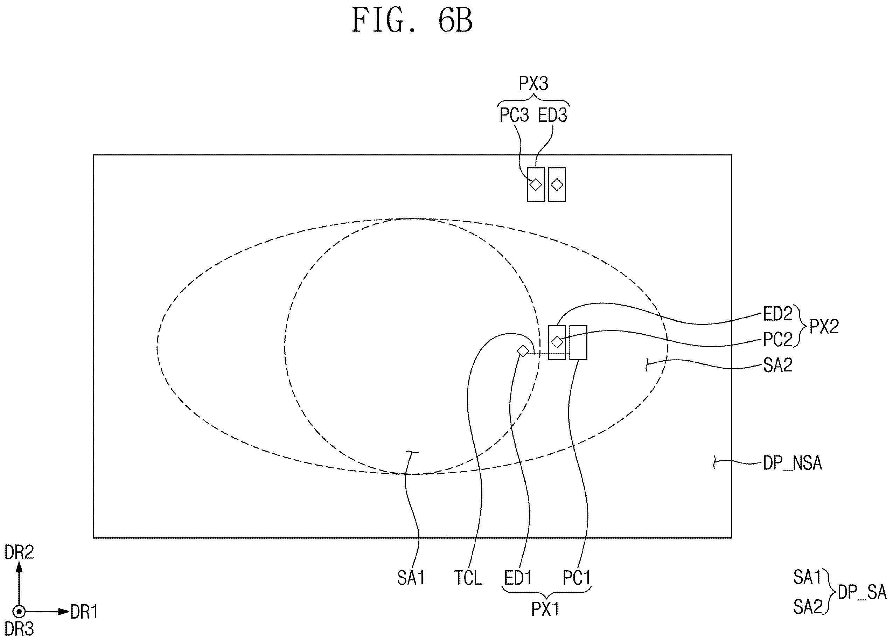

FIG. 6A is a plan view of a display panel according to one or more embodiments of the present invention, and FIG. 6B is an enlarged view obtained by enlarging a partial region illustrated in FIG. 6A.

Referring to FIGS. 6A and 6B, the display panel DP may include a display region DP_DA and a non-display region DP_NDA.

The display region DP_DA may include the first region DP_SA and the second region DP_NSA. The first region DP_SA may have an oval shape, but the present invention is not limited thereto. For example, the first region DP_SA may have various shapes such as a polygonal shape, a circular shape, a figure having at least one curved side, or an amorphous shape. According to one or more embodiments of the present invention, although the first region DP_SA may be positioned to be adjacent to an upper corner of the display region DP_DA, the position of the first region DP_SA is not limited thereto. For example, the first region DP_SA may be positioned at the center of an upper portion of the display region DP_DA.

The second region DP_NSA may be adjacent to the first region DP_SA. Although the first region DP_SA is illustrated in the form surrounded by the second region DP_NSA, the present invention is not limited thereto. For example, the first region DP_SA may be partially surrounded by the second region DP_NSA, and one side of the first region DP_SA may make contact with the non-display region DP_NDA.

The first region DP_SA may include a first sub-region SA1 and a second sub-region SA2. According to one or more embodiments of the present invention, the first sub-region SA1 may have a circular shape. The second sub-region SA2 may be adjacent to the first sub-region SA1. The second sub-region SA2 may include a (2-1)-th sub-region disposed to be adjacent to a first side of the first sub-region SA1 and a (2-2)-th sub-region disposed to be adjacent to a second side of the first sub-region SA1. The first region DP_SA may have the oval shape by the first and second sub-regions SA1 and SA2. Each of the first and second sub-regions SA1 and SA2 is not limited to the above shape, but may have various shapes.

The light transmittance of the first sub-region SA1 may be higher than that of the second sub-region SA2, and the light transmittance of the second sub-region SA2 may be higher than that of the second region DP_NSA.

The pixel PX may include a plurality of pixels. The plurality of pixels PX may include first pixels PX1, second pixels PX2, and third pixels PX3. The first and second pixels PX1 and PX2 may be disposed in the first region DP_SA. The third pixels PX3 may be disposed in the second region DP_NSA.

Each first pixel PX1 includes a first light emitting element ED1 and a first pixel circuit PC1 connected to the first light emitting element ED1. Each second pixel PX2 includes a second light emitting element ED2 and a second pixel circuit PC2 connected to the second light emitting element ED2. The first light emitting element ED1 is disposed in the first sub-region SA1, and the first pixel circuit PC1 is disposed in the second sub-region SA2. Accordingly, the first light emitting element ED1 may be in a non-overlapping state with the first pixel circuit PC1, when viewed in a plan view. The first light emitting element ED1 may be electrically connected to the first pixel circuit PC1 through a connecting line TCL. The second light emitting element ED2 and the second pixel circuit PC2 are disposed in the second sub-region SA2, and overlapped with each other, when viewed in a plan view.

Each third pixel PX3 includes a third light emitting element ED3 and a third pixel circuit PC3 connected to the third light emitting element ED3. The third light emitting element ED3 and the third pixel circuit PC3 are disposed in the second region DP_NSA, and overlapped with each other, when viewed in a plan view.

According to one or more embodiments of the present invention, although the first to third light emitting elements ED1, ED2, and ED3 may have sizes equal to each other, the present invention is not limited thereto. For example, the sizes of the first and second light emitting elements ED1 and ED2 may be greater than the size of the third light emitting element ED3. According to one or more embodiments of the present invention, although the first to third light emitting elements ED1, ED2, and ED3 may have the same shape, the present invention is not limited thereto. For example, the first and second light emitting elements ED1 and ED2 may have the same shape, and the third light emitting element ED3 may have a shape different from the shapes of the first and second light emitting elements ED1 and ED2.

Each of the first and second sub-regions SA1 and SA2 may have a resolution lower than a resolution of the second region DP_NSA. For example, the number of the first light emitting elements ED1, which are provided in a reference area of the first sub-region SA1, may be equal to the number of the second light emitting elements ED2, which are disposed in a reference area of the second sub-region SA2, and may be smaller than the number of the third light emitting elements ED3 disposed in a reference area of the second region DP_NSA. Alternatively, each of the first and second sub-regions SA1 and SA2 may have a resolution equal to a resolution of the second region DP_NSA. For example, the number of the first light emitting elements ED1, which are provided in a reference area of the first sub-region SA1, may be equal to the number of the second light emitting elements ED2, which are disposed in a reference area of the second sub-region SA2, and the number of the third light emitting elements ED3 disposed in the reference area of the second region DP_NSA.

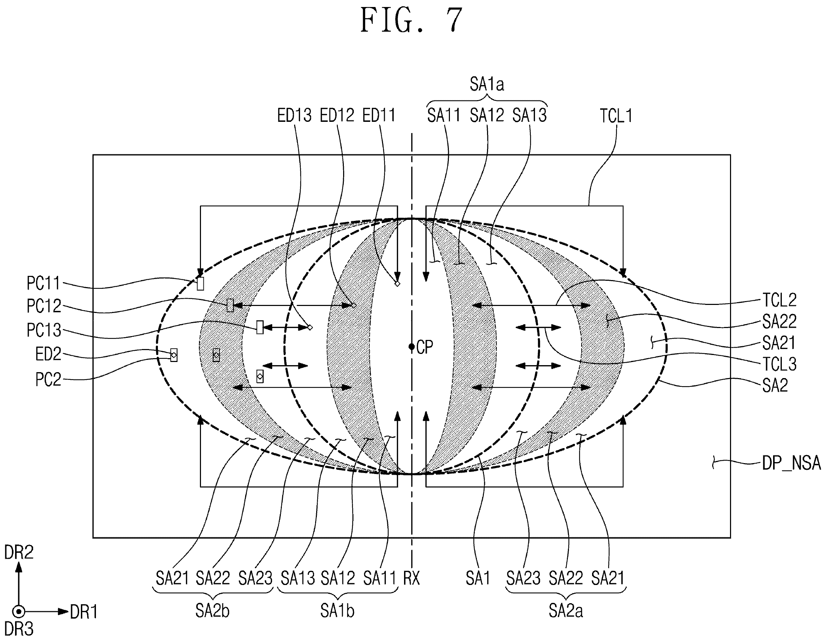

FIG. 7 is a view illustrating an arrangement structure of connecting lines according to one or more embodiments of the present invention.

Referring to FIGS. 6B and 7, the first region DP_SA may include the first sub-region SA1 and the second sub-region SA2. According to one or more embodiments of the present invention, the first sub-region SA1 may have a circular shape. The first sub-region SA1 may be divided into two regions (that is, a (1-1)-th sub-region SA1a and a (1-2)-th sub-region SA1b) with respect to a reference axis RX parallel to the second direction DR2 and passing through the central point CP. In other words, the (1-1)-th sub-region SA1a is disposed at a first side (for example, a right side) about the reference axis RX, and the (1-2)-th sub-region SA1b is disposed at a second side (for example, a left side) about the reference axis RX. The (1-1)-th sub-region SA1a and the (1-2)-th sub-region SA1b may have shapes symmetrical to each other with respect to the reference axis RX. According to one or more embodiments of the present invention, each of the (1-1)-th sub-region SA1a and the (1-2)-th sub-region SA1b may have a semi-circular shape.

Each of the (1-1)-th sub-region SA1a and the (1-2)-th sub-region SA1b may include a plurality of first connecting regions. Although FIG. 7 illustrates the structure including the (1-1)-th sub-region SA1a and the (1-2)-th sub-region SA1b, each of which has three first connecting regions, the present invention is not limited thereto. The three first connecting regions may be referred to as a (1-1)-th connecting region SA11, a (1-2)-th connecting region SA12, and a (1-3)-th connecting region SA13. The (1-1)-th connecting region SA11 is adjacent to the center, and the (1-2)-th connecting region SA12 is disposed outside the (1-1)-th connecting region SA11. The (1-2)-th connecting region SA12 may be disposed to surround the (1-1)-th connecting region SA11. The (1-3)-th connecting region SA13 may be disposed to be adjacent to a boundary between the first and second sub-regions SA1 and SA2. According to one or more embodiments of the present invention, the (1-2)-th connecting region SA12 may be interposed between the (1-1)-th connecting region SA11 and the (1-3)-th connecting region SA13.

A light emitting element, which is disposed in the (1-1)-th connecting region SA11, of the first light emitting elements ED1 is referred to as a (1-1)-th light emitting element ED11. A light emitting element, which is disposed in the (1-2)-th connecting region SA12, of the first light emitting elements ED1 is referred to as a (1-2)-th light emitting element ED12. A light emitting element, which is disposed in the (1-3)-th connecting region SA13, of the first light emitting elements ED1 is referred to as a (1-3)-th light emitting element ED13. A pixel circuit, which is connected to the (1-1)-th light emitting element ED11, of the first pixel circuits PC1 is referred to as a (1-1)-th pixel circuit PC11. A pixel circuit, which is connected to the (1-2)-th light emitting element ED12, of the first pixel circuits PC1 is referred to as a (1-2)-th pixel circuit PC12. A pixel circuit, which is connected to the (1-3)-th light emitting element ED13, of the first pixel circuits PC1 is referred to as a (1-3)-th pixel circuit PC13.

The second sub-region SA2 includes a (2-1)-th sub-region SA2a, which is adjacent to the (1-1)-th sub-region SA1a, and a (2-2)-th sub-region SA2b adjacent to the (1-2)-th sub-region SA1b. In other words, the (2-1)-th sub-region SA2a is interposed between the (1-1)-th sub-region SA1a and the second region DP_NSA, and the (2-2)-th sub-region SA2b is interposed between the (1-2)-th sub-region SA1b and the second region DP_NSA.

Each of the (2-1)-th sub-region SA2a and the (2-2)-th sub-region SA2b may include a plurality of second connecting regions. Although FIG. 7 illustrates the structure including the (2-1)-th sub-region SA2a and the (2-2)-th sub-region SA2b, each of which has three second connecting regions, the present invention is not limited thereto. The three second connecting regions may be referred to as a (2-1)-th connecting region SA21, a (2-2)-th connecting region SA22, and a (2-3)-th connecting region SA23, respectively. The (1-1)-th pixel circuit PC11 connected to the (1-1)-th light emitting element ED11 is disposed in the (2-1)-th connecting region SA21. The (1-2)-th pixel circuit PC12 connected to the (1-2)-th light emitting element ED12 is disposed in the (2-2)-th connecting region SA22. The (1-3)-th pixel circuit PC13 connected to the (1-3)-th light emitting element ED13 is disposed in the (2-3)-th connecting region SA23.

According to one or more embodiments of the present invention, the (2-2)-th connecting region SA22 is disposed to be more adjacent (or closer) to the first sub-region SA1, rather than the (2-1)-th connecting region SA21, and the (2-3)-th connecting region SA23 is disposed to be more adjacent (or closer) to the first sub-region SA1, rather than the (2-2)-th connecting region SA22. Accordingly, the distance between the (1-3)-th connecting region SA13 and the (2-3)-th connecting region SA23 is shorter than the distance between (1-2)-th connecting region SA12 and the (2-2)-th connecting region SA22. The distance between the (1-2)-th connecting region SA12 and the (2-2)-th connecting region SA22 may be shorter than the distance between the (1-1)-th connecting region SA11 and the (2-1)-th connecting region SA21.

The second light emitting elements ED2 and the second pixel circuits PC2 may be disposed in the (2-1)-th to (2-3)-th connecting regions SA21, SA22, and SA23.

The connecting line TCL may include a plurality of connecting lines. The plurality of connecting lines may include first connecting lines TCL1, second connecting lines TCL2, and third connecting lines TCL3. Each of the first connecting lines TCL1 connects the (1-1)-th light emitting element ED11 to the (1-1)-th pixel circuit PC11, and each of the second connecting lines TCL2 connects the (1-2)-th light emitting element ED12 to the (1-2)-th pixel circuit PC12. Each of the third connecting lines TCL3 connects the (1-3)-th light emitting element ED13 to the (1-3)-th pixel circuit PC13.

The length of the first connecting lines TCL1 is longer than the length of the second connecting lines TCL2, and the length of the second connecting lines TCL2 is longer than the length of the third connecting lines TCL3. The line resistance of the first connecting lines TCL1 may be equal to or different from the line resistance of the second connecting lines TCL2. According to one or more embodiments of the present invention, the thickness and the width of the first connecting lines TCL1 are adjusted, such that the line resistance of the first connecting lines TCL1 may be equal to (or substantially equal to) the line resistance of the second connecting lines TCL2. When used herein, the line resistance refers to the electrical resistance of the line.

According to one or more embodiments of the present invention, the first connecting lines TCL1 have lengths equal to each other, and the second connecting lines TCL2 have lengths equal to each other. According to one or more embodiments of the present invention, the first connecting lines TCL1 have line resistances equal to each other, and the second connecting lines TCL2 have line resistances equal to each other. In addition, as the third connecting lines TCL3 have lengths equal to each other, the third connecting lines TCL3 may have line resistances equal to each other.

The first connecting lines TCL1 may extend from the (1-1)-th connecting region SA11 to the (2-1)-th connecting region SA21. The first connecting lines TCL1 may be arranged to be detoured to the second region DP_NSA. Accordingly, some of the first connecting lines TCL1 may be partially overlapped with the second region DP_NSA. The second connecting lines TCL2 may extend from the (1-2)-th connecting region SA12 to the (2-2)-th connecting region SA22. The second connecting lines TCL2 may be partially overlapped with the (1-3)-th and (2-3)-th connecting region SA13 and SA23. The third connecting lines TCL3 may extend from the (1-3)-th connecting region SA13 to the (2-3)-th connecting region SA23.

According to one or more embodiments of the present invention, the first connecting lines TCL1 are disposed on a first layer, the second connecting lines TCL2 are disposed on a second layer, and the third connecting lines TCL3 are disposed on the first layer or the second layer. In other words, the first connecting lines TCL1 and the second connecting lines TCL2 may be disposed on layers different from each other, and the third connecting lines TCL3 may be disposed on a layer that is the same as the layer of the first connecting lines TCL1, or disposed on a layer that is the same as the layer of the second connecting lines TCL2.

As some of the connecting lines TCL1 to TCL3 in the first region DP_SA are detoured to the second region DP_NSA, the connecting lines TCL1 to TCL3 in the first region DP_SA may be disposed on two layers (that is, the first layer and the second layer). Accordingly, the connecting lines TCL1 to TCL3 are efficiently arranged in the confined region to reduce the density of the connecting lines, so the layers may be prevented from being increased to prevent the thickness of the display panel DP from being increased, or to prevent the process mask from being added in manufacturing the display panel DP.

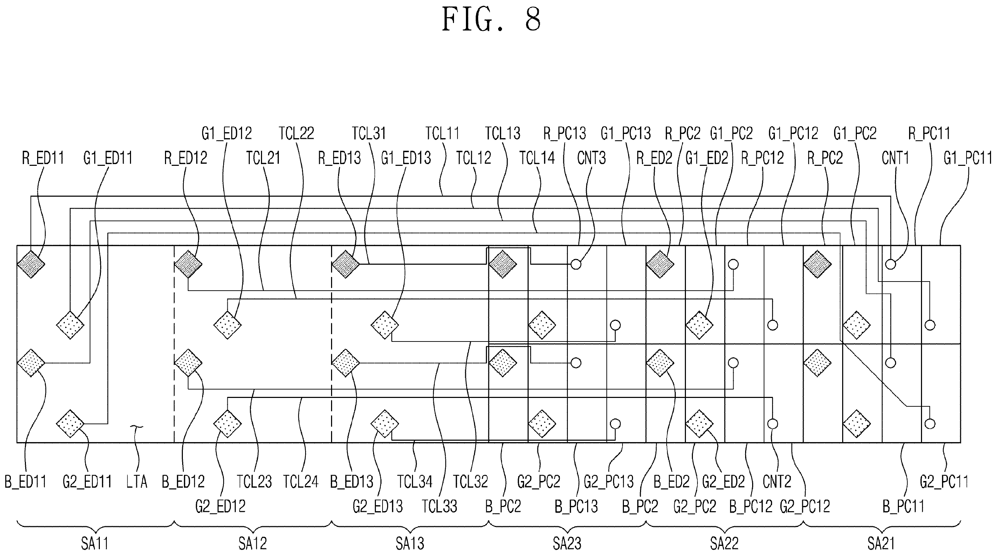

FIG. 8 is a block diagram illustrating the arrangement of first to third connecting lines according to one or more embodiments of the present invention.

Referring to FIGS. 7 and 8, the (1-1)-th light emitting elements ED11, which are disposed in the (1-1)-th connecting region SA11, may include a first red light emitting element R_ED11, a (1-1)-th green light emitting element G1_ED11, a first blue light emitting element B_ED11, and a (1-2)-th green light emitting element G2_ED11. The (1-1)-th pixel circuits PC11 disposed in the (2-1)-th connecting region SA21 may include a first red pixel circuit R_PC11, a (1-1)-th green pixel circuit G1_PC11, a first blue pixel circuit B_PC11, and a (1-2)-th green pixel circuit G2_PC11.

The first connecting lines TCL1 may include a (1-1)-th connecting line TCL11, a (1-2)-th connecting line TCL12, a (1-3)-th connecting line TCL13, and a (1-4)-th connecting line TCL14. The (1-1)-th connecting line TCL11 electrically connects the first red light emitting element R_ED11 to the first red pixel circuit R_PC11. The (1-2)-th connecting line TCL12 electrically connects the (1-1)-th green light emitting element G1_ED11 to the (1-1)-th green pixel circuit G1_PC11. The (1-3)-th connecting lines TCL13 electrically connects the first blue light emitting element B_ED11 to the first blue pixel circuit B_PC11. The (1-4)-th connecting line TCL14 electrically connects the (1-2)-th green light emitting element G2_ED11 to the (1-2)-th green pixel circuit G2_PC11. The (1-1)-th to (1-4)-th connecting lines TCL11, TCL12, TCL13, and TCL14 connect the first red pixel circuit R_PC11, the (1-1)-th green pixel circuit G1_PC11, the first blue pixel circuit B_PC11, and the (1-2)-th green pixel circuit G2_PC11, respectively, through a first contact hole CNT1.

The (1-1)-th to (1-4)-th connecting lines TCL11, TCL12, TCL13, and TCL14 may be detoured to pass through the second region DP_NSA, and may extend from the (2-1)-th connecting region SA21 to the (1-1)-th connecting region SA11. The (1-1)-th to (1-4)-th connecting lines TCL11, TCL12, TCL13, and TCL14 may have shapes different from each other.

The first red pixel circuit R_PC11, the (1-1)-th green pixel circuit G1_PC11, the first blue pixel circuit B_PC11, and the (1-2)-th green pixel circuit G2_PC11 are not disposed in the (1-1)-th connecting region SA11. Accordingly, a region, which is provided from among the first red light emitting element R_ED11, the (1-1)-th green light emitting element G1_ED11, the first blue light emitting element B_ED11, and the (1-2)-th green light emitting element G2_ED11, in the (1-1)-th connecting region SA11 may be defined as a transmissive region LTA to transmit an optical signal.

The (1-2)-th light emitting elements ED12, which are disposed in the (1-2)-th connecting region SA12, may include a second red light emitting element R_ED12, a (2-1)-th green light emitting element G1_ED12, a second blue light emitting element B_ED12, and a (2-2)-th green light emitting element G2_ED12. The (1-2)-th pixel circuits PC12 disposed in the (2-2)-th connecting region SA22 may include a second red pixel circuit R_PC12, a (2-1)-th green pixel circuit G1_PC12, a second blue pixel circuit B_PC12, and a (2-2)-th green pixel circuit G2_PC12.

The second connecting lines TCL2 may include a (2-1)-th connecting line TCL21, a (2-2)-th connecting line TCL22, a (2-3)-th connecting line TCL23, and (2-4)-th connecting lines TCL24. The (2-1)-th connecting line TCL21 electrically connects the second red light emitting element R_ED12 to the second red pixel circuit R_PC12. The (2-2)-th connecting line TCL22 electrically connects the (2-1)-th green light emitting element G1_ED12 to the (2-1)-th green pixel circuit G1_PC12. The (2-3)-th connecting line TCL23 electrically connects the second blue light emitting element B_ED12 to the second blue pixel circuit B_PC12. The (2-4)-th connecting line TCL24 electrically connects the (2-2)-th green light emitting element G2_ED12 to the (2-2)-th green pixel circuit G2_PC12. The (2-1)-th to (2-4)-th connecting lines TCL21, TCL22, TCL23, and TCL24 connect the second red pixel circuit R_PC12, the (2-1)-th green pixel circuit G1_PC12, the second blue pixel circuit B_PC12, and the (2-2)-th green pixel circuit G2_PC12, respectively, through a second contact hole CNT2.

The (2-1)-th to (2-4)-th connecting lines TCL21, TCL22, TCL23, and TCL24 may extend from the (2-2)-th connecting region SA22 to the (1-2)-th connecting region SA12 through the (2-3)-th connecting region SA23 and the (1-3)-th connecting region SA13. According to one or more embodiments, the (2-1)-th connecting line TCL21 and the (2-3)-th connecting line TCL23 may have the same shapes, and the (2-2)-th connecting line TCL22 and the (2-4)-th connecting line TCL24 may have the same shapes. The (2-1)-th to (2-4)-th connecting lines TCL21, TCL22, TCL23, and TCL24 may have lengths equal to each other.

The second red pixel circuit R_PC12, the (2-1)-th green pixel circuit G1_PC12, the second blue pixel circuit B_PC12, and the (2-2)-th green pixel circuit G2_PC12 are not disposed in the (1-2)-th connecting region SA12. Accordingly, a region, which is provided from among the second red light emitting element R_ED12, the (2-1)-th green light emitting element G1_ED12, the second blue light emitting element B_ED12, and the (2-2)-th green light emitting element G2_ED12, in the (1-2)-th connecting region SA12 may be defined as a transmissive region LTA for transmitting an optical signal.

The (1-3)-th light emitting elements ED13, which are disposed in the (1-3)-th connecting region SA13, may include a third red light emitting element R_ED13, a (3-1)-th green light emitting element G1_ED13, a third blue light emitting element B_ED13, and a (3-2)-th green light emitting element G2_ED13. The (1-3)-th pixel circuits PC13 disposed in the (2-3)-th connecting region SA23 may include a third red pixel circuit R_PC13, a (3-1)-th green pixel circuit G1_PC13, a third blue pixel circuit B_PC13, and a (3-2)-th green pixel circuit G2_PC13.

The third connecting lines TCL3 may include a (3-1)-th connecting line TCL31, a (3-2)-th connecting line TCL32, a (3-3)-th connecting line TCL33, and a (3-4)-th connecting line TCL34. The (3-1)-th connecting lines TCL31 electrically connect the third red light emitting element R_ED13 to the third red pixel circuit R_PC13. The (3-2)-th connecting line TCL32 electrically connect the (3-1)-th green light emitting element G1_ED13 to the (3-1)-th green pixel circuit G1_PC13. The (3-3)-th connecting line TCL33 electrically connects the third blue light emitting element B_ED13 to the third blue pixel circuit B_PC13. The (3-4)-th connecting line TCL34 electrically connects the (3-2)-th green light emitting element G2_ED13 to the (3-2)-th green pixel circuit G2_PC13. The (3-1)-th to (3-4)-th connecting lines TCL31, TCL32, TCL33, and TCL34 connect the third red pixel circuit R_PC13, the (3-1)-th green pixel circuit G1_PC13, the third blue pixel circuit B_PC13, and the (3-2)-th green pixel circuit G2_PC13, respectively, through a third contact hole CNT3.

The (3-1)-th to (3-4)-th connecting lines TCL31, TCL32, TCL33, and TCL34 may extend from the (2-3)-th connecting region SA23 to the (1-3)-th connecting region SA13. According to one or more embodiments of the present invention, the (3-1)-th connecting line TCL31 and the (3-3)-th connecting line TCL33 may have the same shapes, and the (3-2)-th connecting line TCL32 and the (3-4)-th connecting line TCL34 may have the same shapes. The (3-1)-th to (3-4)-th connecting lines TCL31, TCL32, TCL33, and TCL34 may have lengths equal to each other.

The third red pixel circuit R_PC13, the (3-1)-th green pixel circuit G1_PC13, the third blue pixel circuit B_PC13, and the (3-2)-th green pixel circuit G2_PC13 are not disposed in the (1-3)-th connecting region SA13. Accordingly, a region, which is provided from among the third red light emitting element R_ED13, the (3-1)-th green light emitting element G1_ED13, the third blue light emitting element B_ED13, and the (3-2)-th green light emitting element G2_ED13, in the (1-3)-th connecting region SA13 may be defined as a transmissive region LTA for transmitting an optical signal.

The second light emitting elements ED2 and the second pixel circuits PC2 may be disposed in the (2-1)-th to (2-3)-th connecting regions SA21, SA22, and SA23. The second light emitting elements ED2 include a fourth red light emitting element R_ED2, a (4-1)-th green light emitting element G1_ED2, a fourth blue light emitting element B_ED2, and a (4-2)-th green light emitting element G2_ED2. The second pixel circuits PC2 include a fourth red pixel circuit R_PC2, a (4-1)-th green pixel circuit G1_PC2, a fourth blue pixel circuit B_PC2, and a (4-2)-th green pixel circuit G2_PC2.

The fourth red light emitting element R_ED2 and the fourth red pixel circuit R_PC2 are electrically connected to each other, and overlapped with each other when viewed in a plan view. The (4-1)-th green light emitting element G1_ ED2 and the (4-1)-th green pixel circuit G1_PC2 are electrically connected to each other, and overlapped with each other when viewed in a plan view. The fourth blue light emitting element B_ED2 and the fourth blue pixel circuit B_PC2 are electrically connected to each other, and overlapped with each other when viewed in a plan view. The (4-2)-th green light emitting element G2_ED2 and the (4-2)-th green pixel circuit G2_PC2 are electrically connected to each other, and overlapped with each other when viewed in a plan view.

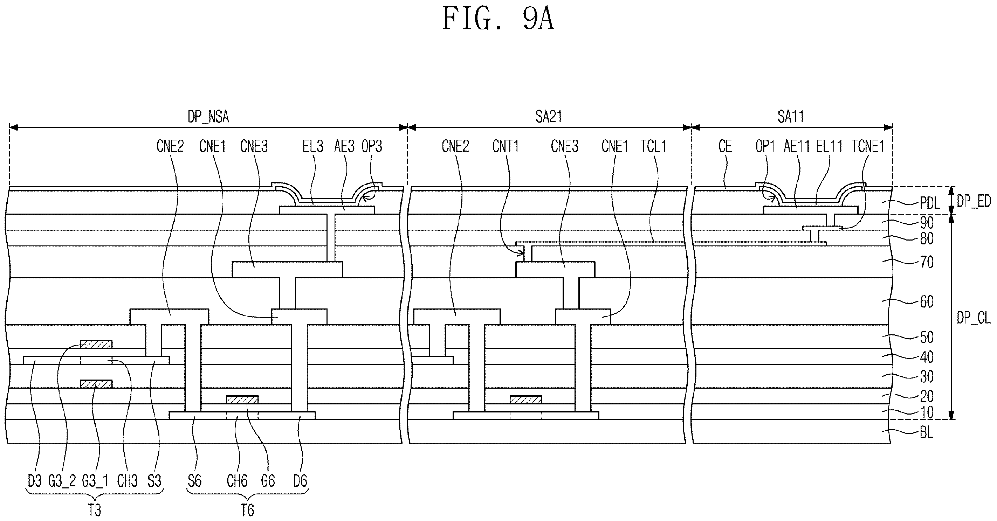

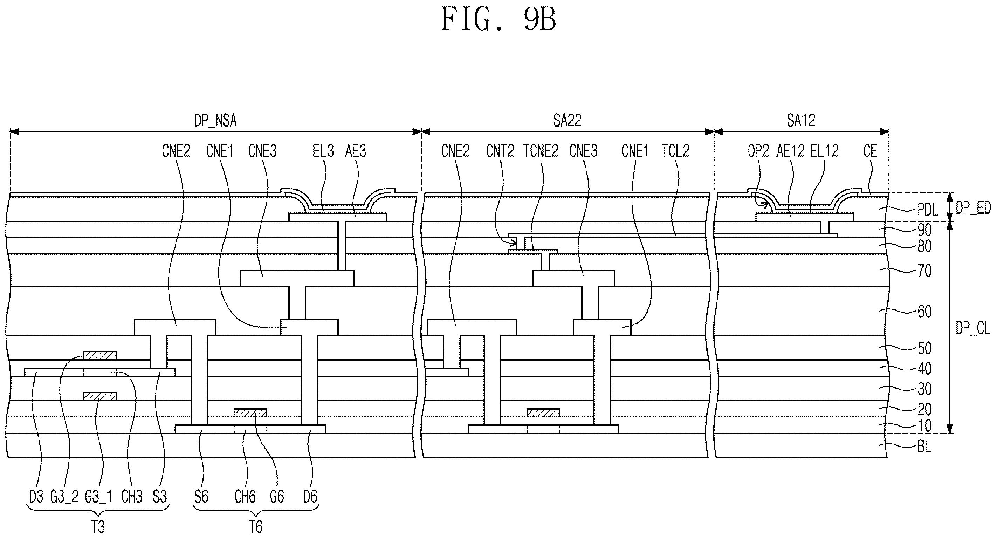

FIGS. 9A and 9B are views illustrating the cross-sectional structure of a first sub-region, a second sub-region, and a second region of a display panel according to one or more embodiments of the present invention. FIG. 9A is a cross-sectional view illustrating the arrangement of a first connecting line, and FIG. 9B is a cross-sectional view illustrating the arrangement of a second connecting line.

Referring to FIGS. 8, 9A, and 9B, the display panel DP may include the base layer BL, the circuit layer DP_CL, and the light emitting element layer DP_ED.

The base layer BL may include a synthetic resin layer. The synthetic resin layer may include a thermosetting resin material. In particular, the synthetic resin layer may be a polyimide-based resin layer, and the material thereof is not particularly limited. The synthetic resin layer may include acrylate-based resin, methacrylate-based resin, polyisoprene-based resin, vinyl-based resin, epoxy-based resin, urethane-based resin, cellulose-based resin, siloxane-based resin, polyamide-based resin, and/or perylene-based resin. In addition, the base layer BL may include a glass substrate, a metal substrate, and/or an organic/inorganic composite material substrate.

The circuit layer DP_CL is disposed on the base layer BL. The circuit layer DP_CL may include at least one inorganic layer disposed on a top surface of the base layer BL. The inorganic layer may include an aluminum oxide, a titanium oxide, a silicon oxide, a silicon oxy nitride, a zirconium oxide, and/or a hafnium oxide. The inorganic layer may be formed in multiple layers. Multiple inorganic layers may constitute a barrier layer and/or a buffer layer. The barrier layer and the buffer layer may be selective disposed.

The barrier layer is disposed on the base layer BL to prevent foreign substances from being introduced from the outside. The barrier layer may include a silicon oxide layer and/or a silicon nitride layer. The silicon oxide layer may include a plurality of silicon oxide layers and the silicon nitride layer may include a plurality of silicon nitride layers, and the silicon oxide layers and the silicon nitride layers may be alternately stacked.

The buffer layer may be disposed on the barrier layer. The buffer layer improves a bonding force between the base layer BL and a semiconductor pattern and/or a conductive pattern. The buffer layer may include a silicon oxide layer and/or a silicon nitride layer. The silicon oxide layer and the silicon nitride layer may be alternately stacked. The barrier layer and the buffer layer may be omitted.

The circuit layer DP_CL includes a first semiconductor pattern disposed on the base layer BL. The first semiconductor pattern may include a silicon semiconductor. The first semiconductor pattern may include lower-temperature polysilicon. However, the present invention is not limited thereto. For example, the first semiconductor pattern may include amorphous silicon or an oxide semiconductor.

The first semiconductor pattern may have an electrical property varied depending on the doping state. Each first semiconductor pattern may include a doping region and a non-doping region. The doping region may be doped with an N-type dopant or a P-type dopant. A P-type transistor includes a doping region doped with the P-type dopant, and an N-type transistor includes a doping region doped with the N-type dopant.

The doping region is greater than the non-doping region in conductivity, and actually serves as an electrode or a signal line. The non-doping region may actually correspond to a channel part CH6 of the transistor. In other words, a first portion of the first semiconductor pattern may be the channel part CH6 of the transistor, and a second portion of the first semiconductor pattern may be a source S6 or drain D6 of the transistor.

As illustrated in FIG. 9A, the first electrode S6, the channel part CH6, and the second electrode D6 of the sixth transistor T6 (corresponding to the sixth transistor T6 illustrated in FIG. 5) are formed from the first semiconductor pattern. The first electrode S6 and the second electrode D6 of the sixth transistor T6 may extend in directions opposite to each other from the channel part CH6.

A first insulating layer (or a gate insulating layer) 10 is disposed on the base layer BL. The first insulating layer 10 covers the first semiconductor pattern. The first insulating layer 10 may be an inorganic layer and/or an organic layer and may have a single-layer or multi-layer structure. The first insulating layer 10 may include an aluminum oxide, a titanium oxide, a silicon oxide, a silicon oxynitride, a zirconium oxide, and/or a hafnium oxide. According to one or more embodiments, the first insulating layer 10 may be a single silicon oxide layer. In addition to the first insulating layer 10, the insulating layers of the circuit layer DP_CL, which are to be described below, may be an inorganic layer and/or an organic layer, and may have a single layer structure or a multi-layer structure. The inorganic layer may include at least one of the above-described materials.

The gate electrode G6 of the sixth transistor T6 is disposed on the first insulating layer 10. The gate electrode G6 of the sixth transistor T6 may be overlapped with the channel part CH6 of the sixth transistor T6. The gate electrode G6 may include titanium, silver, an alloy containing silver, molybdenum, an alloy containing molybdenum, aluminum, an alloy-containing aluminum, aluminum nitride, tungsten, tungsten nitride, copper, indium tin oxide, and/or indium zinc oxide, but the present invention is not limited thereto.

A second insulating layer 20 is disposed on the first insulating layer 10 to cover the gate electrode G6 of the sixth transistor T6. The second insulating layer 20 may be an inorganic layer and/or an organic layer and may have a single-layer or multi-layer structure. According to one or more embodiments, the second insulating layer 20 may be a single silicon oxide layer.

A first gate electrode G3_1 of the third transistor T3 may be disposed on the second insulating layer 20. A third insulating layer 30 is disposed on the second insulating layer 20 to cover the first gate electrode G3_1 of the third transistor T3. According to one or more embodiments, the third insulating layer 30 may be a single silicon oxide layer.

A second semiconductor pattern may be disposed on the third insulating layer 30. The second semiconductor pattern may include an oxide semiconductor. The oxide semiconductor may include a plurality of region that are distinguished depending on whether the metal oxide is reduced. A region (hereinafter referred to as a "reduction region"), in which the metal oxide is reduced, has higher conductivity than a region (hereinafter referred to as a "non-reduction region") in which the metal oxide is not reduced. The reduction region actually serves as a source/drain or signal line of a transistor. The non-reduction region actually corresponds to an active region (or a semiconductor region or a channel region) of a transistor. In other words, a first portion of the second semiconductor pattern may be the channel part of the transistor, a second portion of the second semiconductor pattern may be a source/drain of the transistor, and a third portion of the second semiconductor pattern may be a signal transmitting unit (for example, a bridge line).

A first electrode D3, a channel part CH3, and a second electrode S3 of the third transistor T3 (corresponding to the third transistor T3 illustrated in FIG. 5) may be formed from the second semiconductor pattern. The first gate electrode G3_1 of the third transistor T3 is overlapped with the channel part CH3 of the third transistor T3.

A fourth insulating layer 40 is disposed on the third insulating layer 30. The fourth insulating layer 40 covers the second semiconductor pattern. A second gate electrode G3_2 of the third transistor T3 may be disposed on the fourth insulating layer 40. The second gate electrode G3_2 of the third transistor T3 is overlapped with the channel part CH3 of the third transistor T3 and the first gate electrode G3_1 of the third transistor T3. According to one or more embodiments of the present invention, the second gate electrode G3_2 of the third transistor T3 may be electrically connected to the first gate electrode G3_1 of the third transistor T3.

A fifth insulating layer 50 is disposed on the fourth insulating layer 40 to cover the second gate electrode G3_2 of the third transistor T3. The fourth and fifth insulating layers 40 and 50 may be an inorganic layer and/or an organic layer, and may have a single-layer or multi-layer structure. According to one or more embodiments, the fourth and fifth insulating layers 40 and 50 may be single silicon oxide layers.

First and second connecting electrodes CNE1 and CNE2 are disposed on the fifth insulating layer 50. The first connecting electrode CNE1 electrically connects the second electrode D6 of the sixth transistor T6 to an anode AE3 of the third light emitting element ED3 in the second region DP_NSA, and electrically connects the second electrode D6 of the sixth transistor T6 to an anode AE11 of the (1-1)-th light emitting element ED11 or an anode AE12 of the (1-2)-th light emitting element ED12 in the first region DP_SA. The second connecting electrode CNE2 electrically connects the first electrode S6 of the sixth transistor T6 to the second electrode S3 of the third transistor T3.

A sixth insulating layer 60 is disposed on the fifth insulating layer 50 to cover the first and second connecting electrodes CNE1 and CNE2. A third connecting electrode CNE3 may be disposed on the sixth insulating layer 60. The third connecting electrode CNE3 is connected to the first connecting electrode CNE1 through a contact hole formed through the sixth insulating layer 60. The first to third connecting electrodes CNE1, CNE2, and CNE3 may include, for example, metal, an alloy, a conductive metal oxide, a transparent conductive material.

A seventh insulating layer 70 is disposed on the sixth insulating layer 60 to cover the third connecting electrode CNE3, and the first connecting line TCL1 (or the (1-1)-th connecting line TCL11) and a second intermediate connecting electrode TCNE2 are disposed on the seventh insulating layer (or referred to as a "first layer") 70. According to one or more embodiments, each of the sixth and seventh insulating layers 60 and 70 may include a silicon oxide layer, or a silicon nitride layer. One end (or, referred to as a "first end") of the first connecting line TCL1 is connected to the third connecting electrode CNE3 through the contact hole CNT1 formed through the seventh insulating layer 70, in the (2-1)-th connecting region SA21. The first connecting lines TCL1 may extend from the (2-1)-th connecting region SA21 to the (1-1)-th connecting region SA11. The first connecting line TCL1 and the second intermediate connecting electrode TCNE2 may include a transparent conductive material. The transparent conductive material may include a light transmissive material. The first connecting line TCL1 and the second intermediate connecting electrode TCNE2 may be formed in the form of a film including transparent conductive oxide (TCO) such as indium tin oxide (ITO), indium zinc oxide (IZO), indium gallium zinc oxide (IGZO), zinc oxide (ZnO) and/or indium oxide (In₂O₃).

An eighth insulating layer (or referred to as a "second layer") 80 is disposed on the seventh insulating layer 70 to cover the first connecting line TCL1 and the second intermediate connecting electrode TCNE2, and a second connecting line TCL2 (or the (2-1)-th connecting line TCL21) and a first intermediate connecting electrode TCNE1 are disposed on the eighth insulating layer 80. One end (or, referred to as a "first end") of the second connecting line TCL2 is connected to the second intermediate connecting electrode TCNE2 through the contact hole CNT2, which is formed through the eighth insulating layer 80, in the (2-2)-th connecting region SA22. The second connecting lines TCL2 may extend from the (2-2)-th connecting region SA22 to the (1-2)-th connecting region SA12.

The first intermediate connecting electrode TCNE1 is disposed in the (1-1)-th connecting region SA11, and connected to an opposite end (or referred to as a "second end") of the first connecting line TCL1 through a contact hole, which is formed through the eighth insulating layer 80, in the (1-1)-th connecting region SA11. The second connecting line TCL2 and the first intermediate connecting electrode TCNE1 may include a transparent conductive material. The transparent conductive material may include a light transmissive material. The second connecting line TCL2 and the first intermediate connecting electrode TCNE1 may be formed in the form of a film including transparent conductive oxide (TCO) such as indium tin oxide (ITO), indium zinc oxide (IZO), indium gallium zinc oxide (IGZO), zinc oxide (ZnO), and/or indium oxide (In₂O₃).

As described above, as the first and second connecting lines TCL1 and TCL2, and the first and second intermediate connecting electrodes TCNE1 and TCNE2 include a transparent conductive material, even if the first and second connecting lines TCL1 and TCL2, and the first and second intermediate connecting electrodes TCNE1 and TCNE2 are disposed in the first region DP_SA, the light transmittance of the first region DP_SA may be prevented from being degraded by the first and second connecting lines TCL1 and TCL2, and the first and second intermediate connecting electrodes TCNE1 and TCNE2 disposed in the first region DP_SA.

The second connecting line TCL2 and the first intermediate connecting electrode TCNE1 may include a material that is the same as a material of the first connecting line TCL1 and the second intermediate connecting electrode TCNE2. The first and second connecting lines TCL1 and TCL2 and the first and second intermediate connecting electrode TCNE1 and TCNE2 may include a material that is different from the first to third connecting electrodes CNE1, CNE2, and CNE3, but the present invention is not limited thereto.

Although FIG. 9B illustrates the structure in which the second connecting line TCL2 and the third connecting electrode CNE3 are connected to each other through the second intermediate connecting electrode TCNE2, the present invention is not limited thereto. For example, the first end of the second connecting line TCL2 may be directly connected to the third connecting electrode CNE3. In this case, the second intermediate connecting electrode TCNE2 may be omitted.

A ninth insulating layer 90 is disposed on the eighth insulating layer 80 to cover the second connecting line TCL2 and the first intermediate connecting electrode TCNE1.

The light emitting element layer DP_ED is disposed on the circuit layer DP_CL. The light emitting element layer DP_ED may include the (1-1)-th light emitting element ED11 (or the first red light emitting element R_ED11), the (1-2)-th light emitting element ED12 (or the second red light emitting element R_ED12), the third light emitting element ED3, and the pixel defining layer PDL. The (1-1)-th light emitting element ED11 includes a (1-1)-th anode AE11, a (1-1)-th light emitting layer EL11, and a common cathode CE, and the (1-2)-th light emitting element ED12 includes a (1-2)-th anode AE12, a (1-2)-th light emitting layer EL12, and the common cathode CE. The third light emitting element ED3 includes a third anode AE3, a third light emitting layer EL3, and the common cathode CE.

The (1-1)-th and (1-2)-th anodes AE11 and AE12, and the third anode AE3 are disposed on the ninth insulating layer 90. The third anode AE3 is connected to the third connecting electrode CNE3 through a contact hole formed through the seventh to ninth insulating layers 70, 80, and 90 in the second region DP_NSA. The (1-1)-th anode AE11 is connected to the first intermediate connecting electrode TCNE1 through a contact hole formed through the ninth insulating layer 90 in the (1-1)-th connecting region SA11. The (1-2)-th anode AE12 is connected to an opposite (or referred to as a "second end") of the second connecting line TCL2 through a contact hole formed through the ninth insulating layer 90 in the (1-2)-th connecting region SA12.

Although FIG. 9A illustrates the structure in which the first connecting line TCL1 and the (1-1)-th anode AE11 are connected to each other through the first intermediate connecting electrode TCNE1, the present invention is not limited thereto. For example, the (1-1)-th anode AE11 may be directly connected to the second end of the first connecting line TCL1. In this case, the first intermediate connecting electrode TCNE1 may be omitted.

The (1-1)-th and (1-2)-th anodes AE11 and AE12, and the third anode AE3 may include a reflective layer, which includes silver, magnesium, aluminum, platinum, palladium, gold, nickel, neodymium, iridium, chromium, or a compound thereof, and a transparent electrode layer or a translucent electrode layer formed on the reflective layer. The transparent or translucent electrode layer may include at least one selected from a group consisting of indium tin oxide, indium zinc oxide, indium gallium zinc oxide, zinc oxide or indium oxide, and aluminum-doped zinc oxide. For example, the (1-1)-th and (1-2)-th anodes AE11 and AE12, and the third anode AE3 may include a multi-layer structure in which indium tin oxide, silver, and indium tin oxide are sequentially stacked on each other.

The pixel defining layer PDL may be disposed on the ninth insulating layer 90, and may include first, second, and third openings OP1, OP2, and OP3 defined to correspond to the (1-1)-th light emitting element ED11, the (1-2)-th light emitting element ED12, and the third light emitting element ED3, respectively. The first opening OP1 exposes at least a portion of the (1-1)-th anode AE11 of the (1-1)-th light emitting element ED11, and the second opening OP2 exposes at least a portion of the (1-2)-th anode AE12 of the (1-2)-th light emitting element ED12. The third opening OP3 exposes at least a portion of the third anode AE3 of the third light emitting element ED3. The first to third openings OP1, OP2, and OP3 of the pixel defining layer PDL may define light emitting regions.

The (1-1)-th light emitting layer EL11 is disposed to correspond to the first opening OP1, the (1-2)-th light emitting layer EL12 is disposed to correspond to the second opening OP2, and the third light emitting layer EL3 is disposed to correspond to the third opening OP3. According to one or more embodiments, although the patterned light emitting layers EL11, EL12, and EL3 are illustrated, the present invention is not limited thereto. A common light emitting layer may be disposed in the first to third pixels PX1 to PX3 (see FIG. 6A) in common. In this case, the common light emitting layer may generate a white light or a blue light.

The common cathode CE is disposed on the light emitting layers EL11, EL12, and EL3. The common cathode CE is disposed in the plurality of pixels PX1 to PX3 in common. Alternatively, the common cathode CE may include a first cathode, which is disposed in the first and second pixels PX1 and PX2 in the first region DP_SA in common, and a second cathode that is disposed in the third pixels PX3 in the second region DP_NSA in common. The first cathode and the second cathode may receive second driving voltages ELVSS (see FIG. 5) that are different from each other.

The display panel DP may further include the encapsulating layer TFE (see FIG. 3) to encapsulate the light emitting element layer DP_ED. The encapsulating layer TFE may include at least one organic layer and at least one inorganic layer. The inorganic layer may include an inorganic material, and may protect the light emitting element layer DP_ED from moisture and/or oxygen. The inorganic layer may include a silicon nitride layer, a silicon oxynitride layer, a silicon oxide layer, a titanium oxide layer, and/or an aluminum oxide layer, but the present invention is not limited particularly thereto. The organic layer may include an organic material, and may protect the light emitting element layer DP_ED from foreign substances such as dust particles.

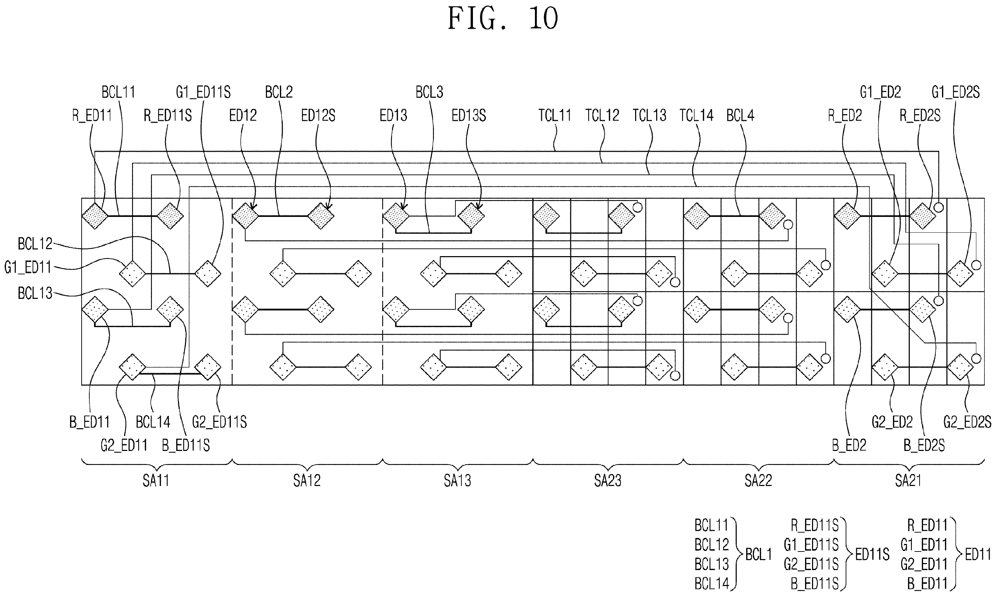

FIG. 10 is a block diagram illustrating the arrangement of first to third connecting lines according to one or more embodiments of the present invention.

Referring to FIGS. 7, 8, and 10, the (1-1)-th light emitting elements ED11 and a (1-1)-th sub-light emitting element ED11S may be disposed in the (1-1)-th connecting region SA11. The (1-1)-th light emitting elements ED11 are electrically connected to the (1-1)-th sub-light emitting elements ED11S through a first bridge line BCL1.

The (1-1)-th light emitting elements ED11 may include the first red light emitting element R_ED11, the (1-1)-th green light emitting element G1_ED11, the first blue light emitting element B_ED11, and the (1-2)-th green light emitting element G2_ED11. The (1-1)-th sub-light emitting elements ED11S may include a first sub-red light emitting element R_ED11S, a (1-1)-th sub-green light emitting element G1_ED11S, a first sub-blue light emitting element B_ED11S, and a (1-2)-th sub-green light emitting element G2_ED11S.

The first bridge lines BCL1 may include a (1-1)-th bridge line BCL11, a (1-2)-th bridge line BCL12, a (1-3)-th bridge line BCL13, and a (1-4)-th bridge line BCL14. The (1-1)-th bridge line BCL11 electrically connects the first red light emitting element R_ED11 to the first sub-red light emitting element R_ED11S, and the (1-2)-th bridge line BCL12 electrically connects the (1-1)-th green light emitting element G1_ED11 to the (1-1)-th sub-green light emitting element G1_ED11S. The (1-3)-th bridge line BCL13 electrically connects the first blue light emitting element B_ED11 to the first sub-blue light emitting element B_ED11S, and the (1-4)-th bridge line BCL14 electrically connects the (1-2)-th green light emitting element G2_ED11 to the (1-2)-th sub-green light emitting element G2_ED11S.

The (1-1)-th pixel circuits PC11 disposed in the (2-1)-th connecting region SA21 may include the first red pixel circuit R_PC11, the (1-1)-th green pixel circuit G1_PC11, the first blue pixel circuit B_PC11, and the (1-2)-th green pixel circuit G2_PC11 (e.g., see FIG. 8).

The first connecting lines TCL1 may include the (1-1)-th connecting line TCL11, the (1-2)-th connecting line TCL12, the (1-3)-th connecting line TCL13, and the (1-4)-th connecting line TCL14 (e.g., see FIG. 8). The (1-1)-th connecting line TCL11 electrically connects the first red light emitting element R_ED11 to the first red pixel circuit R_PC11. The (1-2)-th connecting line TCL12 electrically connects the (1-1)-th green light emitting element G1_ED11 to the (1-1)-th green pixel circuit G1_PC11. The (1-3)-th connecting line TCL13 electrically connects the first blue light emitting element B_ED11 to the first blue pixel circuit B_PC11. The (1-4)-th connecting line TCL14 electrically connects the (1-2)-th green light emitting element G2_ED11 to the (1-2)-th green pixel circuit G2_PC11. The (1-1)-th to (1-4)-th connecting lines TCL11, TCL12, TCL13, and TCL14 connect the first red pixel circuit R_PC11, the (1-1)-th green pixel circuit G1_PC11, the first blue pixel circuit B_PC11, and the (1-2)-th green pixel circuit G2_PC11, respectively, through the first contact hole CNT1.

The first red light emitting element R_ED11 and the first sub-red light emitting element R_ED11S concurrently (e.g., simultaneously) emit light by the first red pixel circuit R_PC11. The (1-1)-th green light emitting element G1_ED11 and the (1-1)-th sub-green light emitting element G1_ED11S concurrently (e.g., simultaneously) emit light by the (1-1)-th green pixel circuit G1_PC11. The first blue light emitting element B_ED11 and the first sub-blue light emitting element B_ED11S concurrently (e.g., simultaneously) emit light by the first blue pixel circuit B_PC11. The (1-2)-th green light emitting element G2_ED11 and the (1-2)-th sub-green light emitting element G2_ED11S concurrently (e.g., simultaneously) emit light by the (1-2)-th green pixel circuit G2_PC11.

The (1-2)-th light emitting elements ED12 and the (1-2)-th sub-light emitting elements ED12S may be disposed in the (1-2)-th connecting region SA12. The (1-2)-th light emitting elements ED12 are electrically connected to the (1-2)-th sub-light emitting elements ED12S through a second bridge line BCL2. The (1-2)-th light emitting elements ED12 are electrically connected to the (1-2)-th pixel circuits PC12 (s.g., see FIG. 7) disposed in the (2-2)-th connecting region SA22 through the second connecting line TCL2 (e.g., see FIG. 7). Accordingly, the (1-2)-th light emitting elements ED12 and the (1-2)-th sub-light emitting element ED12S concurrently (e.g., simultaneously) emit light by the (1-2)-th pixel circuits PC12.

The (1-3)-th light emitting elements ED13 and the (1-3)-th sub-light emitting elements ED13S may be disposed in the (1-3)-th connecting region SA13. The (1-3)-th light emitting elements ED13 are electrically connected to the (1-3)-th sub-light emitting elements ED13S through a third bridge line BCL3. The (1-3)-th light emitting elements ED13 are electrically connected to the (1-3)-th pixel circuits PC13 (e.g., see FIG. 7) disposed in the (2-3)-th connecting region SA23 through the third connecting line TCL3 (e.g., see FIG. 7). Accordingly, the (1-3)-th light emitting elements ED13 and the (1-3)-th sub-light emitting elements ED13S concurrently (e.g., simultaneously) emit light by the (1-3)-th pixel circuits PC13.

A fourth red light emitting element R_ED2, a fourth sub-red light emitting element R_ED2S, a (4-1)-th green light emitting element G1_ED2, a (4-1)-th sub-green light emitting element G1_ED2S, a fourth blue light emitting element B_ED2, a fourth sub-blue light emitting element B_ED2S, a (4-2)-th green light emitting element G2_ED2 and a (4-2)-th sub-green light emitting element G2_ED2S are disposed in the (2-1)-th connecting region SA21. A fourth bridge line BCL4 electrically connects the fourth red light emitting element R_ED2 to the fourth sub-red light emitting element R_ED2S, electrically connects the (4-1)-th green light emitting element G1_ED2 to the (4-1)-th sub-green light emitting element G1_ED2S, electrically connects the fourth blue light emitting element B_ED2 to the fourth sub-blue light emitting element B_ED2S, and electrically connects the (4-2)-th green light emitting element G2_ED2 to the (4-2)-th sub-green light emitting element G2_ED2S.

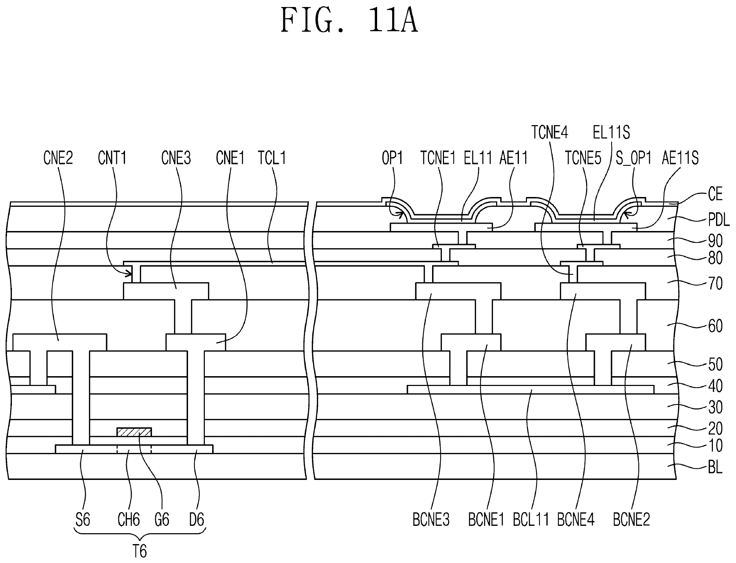

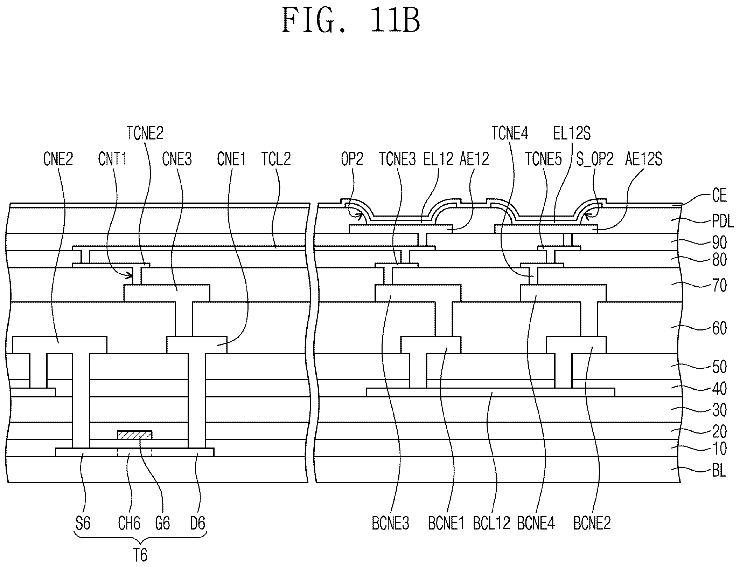

FIGS. 11A and 11B are views illustrating cross-sectional structures of a first region and a second region of a display panel according to one or more embodiments of the present invention. FIG. 11A is a cross-sectional view illustrating the arrangement of a first connecting line, and FIG. 11B is a cross-sectional view illustrating the arrangement of a second connecting line. Components, which are the same as the components illustrated in FIGS. 9A and 9B, from among components illustrated in FIGS. 11A and 11B will be assigned with the same reference numerals, and the details thereof will be omitted to avoid redundancy.

Referring to FIGS. 11A and 11B, a first semiconductor pattern may be disposed on the base layer BL. A first electrode S6, a channel part CH6, and a second electrode D6 of the sixth transistor T6 (corresponding to the sixth transistor T6 illustrated in FIG. 5) are formed from the first semiconductor pattern. The gate electrode G6 of the sixth transistor T6 is overlapped with the channel part CH6 of the sixth transistor T6.

The first to third bridge lines BCL1 to BCL3 illustrated in FIG. 10 may be formed from the second semiconductor pattern. For example, the first to third bridge lines BCL1 to BCL3 may be reduction regions of the second semiconductor pattern. Although the first to third bridge lines BCL1 to BCL3 may include indium gallium zinc oxide (IGZO), a material constituting the first to third bridge lines BCL1 to BCL3 is not particularly limited thereto.

The first to third bridge lines BCL1 to BCL3 are covered by the fourth insulating layer 40.

First and second connecting electrodes CNE1 and CNE2, and first and second bridge electrodes BCNE1 and BCNE2 are disposed on the fifth insulating layer 50. The first bridge electrode BCNE1 is connected to one end (for example, a first end) of each of the first to third bridge lines BCL1 to BCL3 through a contact hole formed through the fourth and fifth insulating layers 40 and 50. The second bridge electrode BCNE2 is connected to an opposite end (for example, a second end) of each of the first to third bridge lines BCL1 to BCL3 through a contact hole formed through the fourth and fifth insulating layers 40 and 50.

The sixth insulating layer 60 is disposed to cover the first and second connecting electrodes CNE1 and CNE2, and the first and second bridge electrodes BCNE1 and BCNE2. Third connecting electrode CNE3, and third and fourth bridge electrodes BCNE3 and BCNE4 may be disposed on the sixth insulating layer 60. The third bridge electrode BCNE3 is connected to the first bridge electrode BCNE1 through a contact hole formed through the sixth insulating layer 60, and the fourth bridge electrode BCNE4 is connected to the second bridge electrode BCNE2 through the contact hole formed through the sixth insulating layer 60. The first to fourth bridge electrodes BCNE1 to BCNE4 may include, for example, metal, an alloy, conductive metal oxide, and a transparent conductive material.

The seventh insulating layer 70 is disposed on the sixth insulating layer 60 to cover the third connecting electrode CNE3, and the third and fourth bridge electrodes BCNE3 and BCNE4, and the first connecting line TCL1 and the second to fourth intermediate connecting electrodes TCNE2, TCNE3, and TCNE4 are disposed on the seventh insulating layer 70 (or referred to as the "first layer"). The first connecting line TCL1, and the second to fourth intermediate connecting electrodes TCNE2 to TCNE4 may include a transparent conductive material. The second intermediate connecting electrode TCNE2 is connected to the third connecting electrode CNE3 through a contact hole formed through the seventh insulating layer 70. The third intermediate connecting electrode TCNE3 is connected to the third bridge electrode BCNE3 through the contact hole formed through the seventh insulating layer 70, and the fourth intermediate connecting electrode TCNE4 is connected to the fourth bridge electrode BCNE4 through the contact hole formed through the seventh insulating layer 70.

An eighth insulating layer 80 (or referred to as a "second layer") is disposed on the seventh insulating layer 70 to cover the first connecting line TCL1 and the second to fourth intermediate connecting electrodes TCNE2, TCNE3, and TCNE4, and the second connecting line TCL2 and first and fifth intermediate connecting electrodes TCNE1 and TCNE5 are disposed on the eighth insulating layer 80. The one end (or, referred to as the "first end") of the second connecting line TCL2 is connected to the second intermediate connecting electrode TCNE2 through the contact hole CNT2 formed through the eighth insulating layer 80, in the (2-2)-th connecting region SA22.

The first intermediate connecting electrode TCNE1 is disposed in the (1-1)-th connecting region SA11, and is connected to the opposite end (or referred to as a "second end") of the first connecting line TCL1 through a contact hole formed through the eighth insulating layer 80 in the (1-1)-th connecting region SA11. The fifth intermediate connecting electrode TCNE5 is connected to the fourth intermediate connecting electrode TCNE4 through the contact hole formed through the eighth insulating layer 80. Alternatively, the fifth intermediate connecting electrode TCNE5 may be directly connected to the fourth bridge electrode BCNE4 through the contact hole formed through the seventh and eighth insulating layers 70 and 80.

Although FIG. 11B illustrates the structure in which the fifth intermediate connecting electrode TCNE5 is connected to the fourth intermediate connecting electrode TCNE4, the present invention is not limited thereto. For example, the fifth intermediate connecting electrode TCNE5 may be directly connected to the fourth bridge electrode BCNE4, the fourth intermediate connecting electrode TCNE4 may be omitted.

A ninth insulating layer 90 is disposed on the eighth insulating layer 80 to cover the second connecting line TCL2, the first intermediate connecting electrode TCNE1 and the fifth intermediate connecting electrode TCNE5.

The first and second connecting lines TCL1 and TCL2 may include transparent conductive materials. Even if the first and second connecting lines TCL1 and TCL2 are disposed in the first region DP_SA, the light transmittance of the first region DP_SA may be prevented from being degraded due to the first and second connecting lines TCL1 and TCL2. Alternatively, when even the first to third bridge lines BCL1 to BCL3 include a transparent conductive oxide, the light transmittance of the first region DP_SA may be more improved.

The light emitting element layer DP_ED is disposed on the circuit layer DP_CL. The light emitting element layer DP_ED may include the (1-1)-th light emitting element ED11, the (1-1)-th sub-light emitting element ED11S, the (1-2)-th light emitting element ED12, the (1-2)-th sub-light emitting element ED12S, the third light emitting element ED3, and the pixel defining layer PDL. The (1-1)-th light emitting element ED11 includes a (1-1)-th anode AE11, a (1-1)-th light emitting layer EL11, and a common cathode CE, and the (1-1)-th sub-light emitting element ED11S includes a (1-1)-th sub-anode AE11S, a (1-1)-th sub-light emitting layer EL11S, and a common cathode CE. The (1-2)-th light emitting element ED12 includes a (1-2)-th anode AE12, a (1-2)-th light emitting layer EL2, and a common cathode CE, and the (1-2)-th sub-light emitting element ED12S includes the (1-2)-th sub-anode AE12S, the (1-2)-th sub-light emitting layer EL12S, and the common cathode CE.

The (1-1)-th and (1-2)-th anodes AE11 and AE12, and the (1-1)-th and (1-2)-th sub-anodes AE11S and AE12S are disposed on the ninth insulating layer 90. The (1-1)-th anode AE11 is connected to the first intermediate connecting electrode TCNE1 through a contact hole formed through the ninth insulating layer 90 in the (1-1)-th connecting region SA11. The (1-2)-th anode AE12 is connected to an opposite end (or referred to as a "second end") of the second connecting line TCL2 through a contact hole formed through the ninth insulating layer 90 in the (1-2)-th connecting region SA12. The (1-1)-th and (1-2)-th sub-anodes AE11S and AE12S are connected to the fifth intermediate connecting electrode TCNE5 through a contact hole formed through the ninth insulating layer 90.

Although FIGS. 11A and 11B illustrate the structures in which the (1-1)-th and (1-2)-th sub-anodes AE11S and AE12S are connected to the fourth intermediate connecting electrode TCNE4 though the fifth intermediate connecting electrode TCNE5, the present invention is not limited thereto. For example, the (1-1)-th and (1-2)-th sub-anodes AE11S and AE12S may be directly connected to the fourth intermediate connecting electrode TCNE4 or the fourth bridge electrode BCNE4. In this case, the fourth intermediate connecting electrode TCNE4 or the fifth intermediate connecting electrode TCNE5 may be omitted.

The pixel defining layer PDL may be disposed on the ninth insulating layer 90, and may include first, second, and third openings OP1, OP2, and OP3 defined to correspond to the (1-1)-th light emitting element ED11, the (1-2)-th light emitting element ED12, and the third light emitting element ED3, respectively, and first and second sub-openings S_OP1 and S_OP2 defined to correspond to the (1-1)-th sub-light emitting element ED11S and the (1-2)-th sub-light emitting element ED12S, respectively. The first opening OP1 exposes at least a portion of the (1-1)-th anode AE11 of the (1-1)-th light emitting element ED11, and the second opening OP2 exposes at least a portion of the (1-2)-th anode AE12 of the (1-2)-th light emitting element ED12. The third opening OP3 exposes at least a portion of the third anode AE3 of the third light emitting element ED3 (e.g., see FIGS. 9A-9B). The first sub-opening S_OP1 exposes at least a portion of the (1-1)-th sub-anode AE11S of the (1-1)-th sub-light emitting element ED11S, and the second sub-opening S_OP2 exposes at least a portion of the (1-2)-th sub-anode AE12S of the (1-2)-th sub-light emitting element ED12S. The first to third openings OP1, OP2, and OP3 of the pixel defining layer PDL may define light emitting regions.

The (1-1)-th sub light emitting layer EL11S is disposed to correspond to the first sub-opening S_OP1, and the (1-2)-th sub-light emitting layer EL12S is disposed to correspond to the second sub-opening S_OP2.

The common cathode CE is disposed on the light emitting layers EL11, EL12, and EL3 and the sub-light emitting layers EL11S, and EL12S. The common cathode CE is disposed in the plurality of pixels PX1 to PX3 (see FIG. 6A) in common. Alternatively, the common cathode CE may include a first common cathode, which is disposed in the first and second pixels PX1 and PX2 in the first region DP_SA in common, and a second common cathode which is disposed in the third pixels PX3 in the second region DP_NSA in common. The first common cathode and the second common cathode may receive second driving voltages ELVSS (see FIG. 5) that are different from each other.

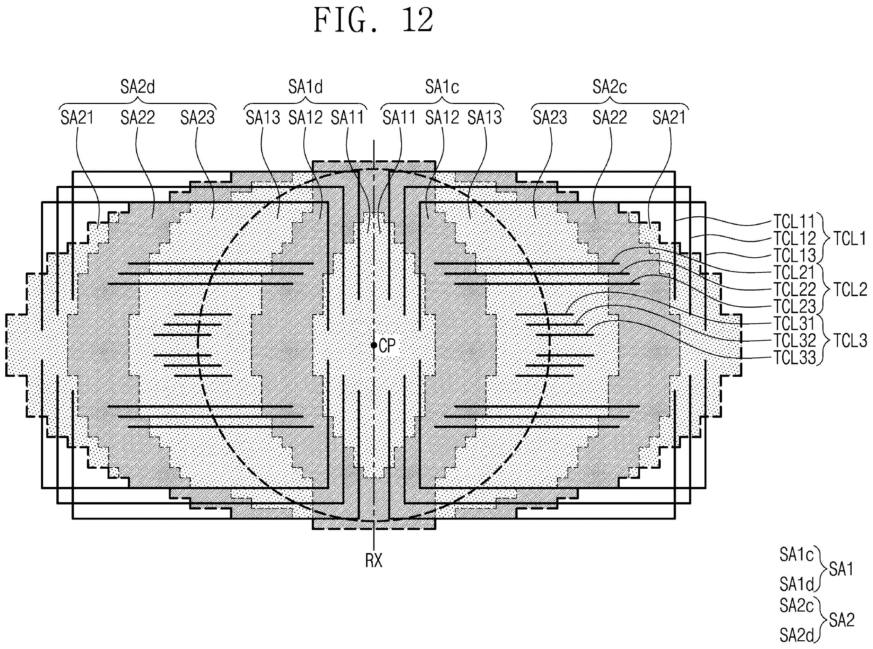

FIG. 12 is a block diagram illustrating the lengths of the first to third connecting lines according to one or more embodiments of the present invention. Components, which are the same as the components illustrated in FIG. 7, from among components illustrated in FIG. 12 will be assigned with the same reference numerals, and the details thereof will be omitted to avoid redundancy.

Referring to FIG. 12, the first region DP_SA may include the first sub-region SA1 and the second sub-region SA2. According to one or more embodiments of the present invention, the first sub-region SA1 may have an angled circular shape. The first sub-region SA1 may be divided into two regions (that is, a (1-1)-th sub-region SA1c and a (1-2)-th sub-region SA1d) about a reference axis RX, which is parallel to the second direction DR2 and passes through the central point CP. In other words, the (1-1)-th sub-region SA1c is disposed at a first side (for example, a right side) about the reference axis RX, and the (1-2)-th sub-region SA1d is disposed at a second side (for example, a left side) about the reference axis RX. The (1-1)-th sub-region SA1c and the (1-2)-th sub-region SA1d may have shapes symmetrical to each other about the reference axis RX. According to one or more embodiments of the present invention, each of the (1-1)-th sub-region SA1c and the (1-2)-th sub-region SA1d may have an angled semi-circular shape.

Each of the (1-1)-th sub-region SA1c and the (1-2)-th sub-region SA1d may include a plurality of first connecting regions. Although FIG. 12 illustrates the structure including the (1-1)-th sub-region SA1c and the (1-2)-th sub-region SA1d, each of which has three first connecting regions, the present invention is not limited thereto. The three first connecting regions may be referred to as a (1-1)-th connecting region SA11, a (1-2)-th connecting region SA12, and a (1-3)-th connecting region SA13, respectively. The (1-1)-th connecting region SA11 is adjacent to the center, and the (1-2)-th connecting region SA12 is disposed outside the (1-1)-th connecting region SA11. The (1-2)-th connecting region SA12 may be disposed to be around (e.g., to surround) the (1-1)-th connecting region SA11. The (1-3)-th connecting region SA13 may be disposed to be adjacent to a boundary between the first and second sub-regions SA1 and SA2. According to one or more embodiments of the present invention, boundary lines having stepped shapes may be formed between the (1-1)-th connecting region SA11 and the (1-2)-th connecting region SA12, and between the (1-2)-th connecting region SA12 and the (1-3)-th connecting region SA13.

The second sub-region SA2 includes a (2-1)-th sub-region SA2c, which is adjacent to the (1-1)-th sub-region SA1c, and a (2-2)-th sub-region SA2d adjacent to the (1-2)-th sub-region SA1d. In other words, the (2-1)-th sub-region SA2c is interposed between the (1-1)-th sub-region SA1c and the second region DP_NSA, and the (2-2)-th sub-region SA2d is interposed between the (1-2)-th sub-region SA1d and the second region DP_NSA.

Each of the (2-1)-th sub-region SA2c and the (2-2)-th sub-region SA2d may include a plurality of second connecting regions. Although FIG. 12 illustrates the structure including the (2-1)-th sub-region SA2c and the (2-2)-th sub-region SA2d, each of which has three second connecting regions, the present invention is not limited thereto. The three second connecting regions may be referred to as the (2-1)-th connecting region SA21, the (2-2)-th connecting region SA22, and the (2-3)-th connecting region SA23, respectively. According to one or more embodiments of the present invention, boundary lines having stepped shapes may be formed between the (2-1)-th connecting region SA21 and the (2-2)-th connecting region SA22, and between the (2-2)-th connecting region SA22 and the (2-3)-th connecting region SA23.

Accordingly, the distance between the (1-3)-th connecting region SA13 and the (2-3)-th connecting region SA23 is shorter than the distance between (1-2)-th connecting region SA12 and the (2-2)-th connecting region SA22. The distance between the (1-2)-th connecting region SA12 and the (2-2)-th connecting region SA22 may be shorter than the distance between the (1-1)-th connecting region SA11 and the (2-1)-th connecting region SA21.

The connecting line TCL may include a plurality of connecting lines. The plurality of connecting lines may include the first connecting lines TCL1, the second connecting lines TCL2, and the third connecting lines TCL3. The length of the first connecting lines TCL1 is longer than the length of the second connecting lines TCL2, and the length of the second connecting lines TCL2 is longer than the length of the third connecting lines TCL3.

According to one or more embodiments of the present invention, the first connecting lines TCL1 may include the (1-1)-th connecting line TCL11, the (1-2)-th connecting line TCL12, and the (1-3)-th connecting line TCL13. The (1-1)-th connecting line TCL11, the (1-2)-th connecting line TCL12, and the (1-3)-th connecting line TCL13 have lengths equal to (or substantially equal to) each other. The (1-1)-th connecting line TCL11, the (1-2)-th connecting line TCL12, and the (1-3)-th connecting line TCL13 may have equal line resistances. The second connecting lines TCL2 may include the (2-1)-th connecting line TCL21, the (2-2)-th connecting line TCL22, and the (2-3)-th connecting line TCL23. The (2-1)-th connecting line TCL21, the (2-2)-th connecting line TCL22, and the (2-3)-th connecting line TCL23 have lengths equal to (or substantially equal to) each other. The (2-1)-th connecting line TCL21, the (2-2)-th connecting line TCL22, and the (2-3)-th connecting line TCL23 may have equal line resistances. The third connecting lines TCL3 may include the (3-1)-th connecting line TCL31, the (3-2)-th connecting line TCL32, and the (3-3)-th connecting line TCL33. The (3-1)-th connecting line TCL31, the (3-2)-th connecting line TCL32, and the (3-3)-th connecting line TCL33 have lengths equal to (or substantially equal to) each other. The (3-1)-th connecting line TCL31, the (3-2)-th connecting line TCL32, and the (3-3)-th connecting line TCL33 may have equal line resistances.

Even the first to third connecting lines TCL1, TCL2, and TCL3 having no equal lengths may have equal line resistances.

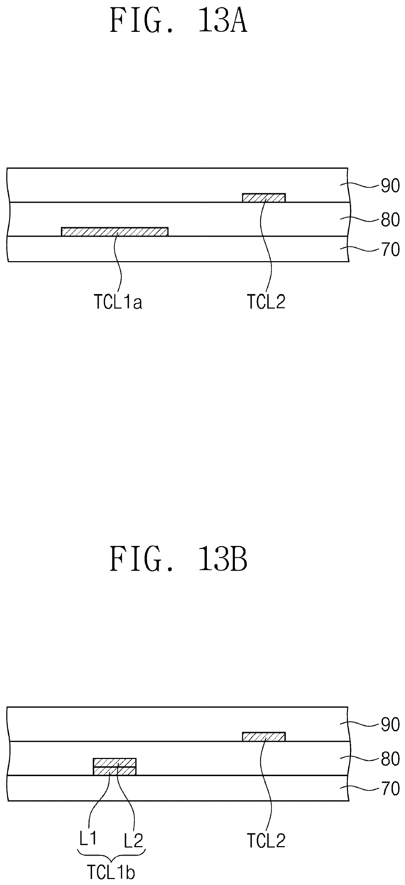

FIGS. 13A and 13B are cross-sectional views illustrating the first and second connecting lines according to one or more embodiments of the present invention. In FIG. 13A, a first connecting line TCL1a may have a width wider than a width of the second connecting line TCL2. In FIG. 13B, a first connecting line TCL1b may have a thickness thicker than a thickness of the second connecting line TCL2.

Referring to FIG. 13A, the first connecting line TCL1a may be disposed on the seventh insulating layer 70, and the second connecting line TCL2 may be disposed on the eighth insulating layer 80. Because the first connecting line TCL1a may have a length longer than a length of the second connecting line TCL2, a line resistance of the first connecting line TCL1a may be greater than a line resistance of the second connecting line TCL2. However, the width of the first connecting line TCL1a may be adjusted to compensate for the difference in line resistance between the first and second connecting lines TCL1a and TCL2. In other words, when the width of the first connecting line TCL1a is wider than the width of the second connecting line TCL2, the difference in line resistance, which is caused by the difference in length between the first and second connecting lines TCL1a and TCL2, may be compensated. In other words, even if the first and second connecting lines TCL1a and TCL2 have lengths different from each other, the first and second connecting lines TCL1a and TCL2 may have the equal line resistance.

Referring to FIG. 13B, the thickness of the first connecting line TCL1b may be adjusted to compensate for the difference in line resistance between the first and second connecting lines TCL1b and TCL2. In other words, when the thickness of the first connecting line TCL1b is thicker than the thickness of the second connecting line TCL2, the difference in line resistance, which is caused by the difference in length between the first and second connecting lines TCL1b and TCL2, may be compensated. In other words, even if the first and second connecting lines TCL1b and TCL2 have lengths different from each other, the first and second connecting lines TCL1b and TCL2 may have the equal line resistance.

The first connecting line TCL1b may have a multi-layer stack structure (for example, a two-layer stack structure or a three-layer stack structure). According to one or more embodiments of the present invention, when the first connecting line TCL1b has the two-layer stack structure, the first connecting line TCL1b may include a first layer line L1 and a second layer line L2 disposed on the first layer line L1. In one or more embodiments, the second connecting line TCL2 may have a single layer structure.

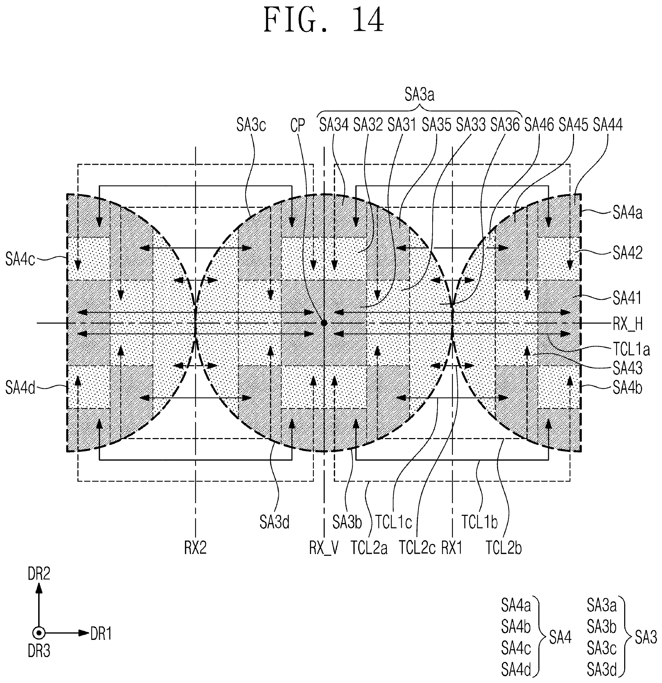

FIG. 14 is a view illustrating the shape of a first region and the arrangement structure of connecting lines resulting from the shape according to one or more embodiments of the present invention.

Referring to FIG. 14, the first region DP_SA may include a first sub-region SA3 and a second sub-region SA4. According to one or more embodiments of the present invention, the first sub-region SA3 may have a circular shape. The first sub-region SA3 may be divided into four regions (that is, a (1-1)-th sub-region SA3a, a (1-2)-th sub-region SA3b, a (1-3)-th sub-region SA3c, and a (1-4)-th sub-region SA3d), about a vertical reference axis RX_V, which is parallel to the second direction DR2 and passes through the central point CP, and a horizontal reference axis RX_H. In other words, the (1-1)-th sub-region SA3a and the (1-2)-th sub-region SA3b are disposed at a first side (for example, a right side) about the vertical reference axis RX_V, and the (1-3)-th sub-region SA3c and the (1-4)-th sub-region SA3d are disposed at a second side (for example, a left side) about the vertical reference axis RX_V. The (1-1)-th sub-region SA3a is disposed above the (1-2)-th sub-region SA3b, when viewed in the horizontal reference axis RX_H, and the (1-3)-th sub-region SA3c is disposed above the (1-4)-th sub-region SA3d when viewed in the horizontal reference axis RX_H.

The (1-1)-th sub-region SA3a and the (1-2)-th sub-region SA3b have shapes symmetrical to each other about the horizontal reference axis RX_H. The (1-1)-th sub-region SA3a and the (1-3)-th sub-region SA3c may have shapes symmetrical to each other about the vertical reference axis RX_V. The (1-3)-th sub-region SA3c and the (1-4)-th sub-region SA3d have shapes symmetrical to each other about the horizontal reference axis RX_H. The (1-2)-th sub-region SA3b and the (1-4)-th sub-region SA3d may have shapes symmetrical to each other about the vertical reference axis RX_V.

Each of the (1-1)-th to (1-4)-th sub-regions SA3a to SA3d may include a plurality of first connecting regions. Although FIG. 14 illustrates the structure including the (1-1)-th to (1-4)-th sub-regions SA3a to SA3d, each of which has six first connecting regions, the present invention is not limited thereto. The sixth first connecting regions may be referred to as a (1-1)-th connecting region SA31, a (1-2)-th connecting region SA32, a (1-3)-th connecting region SA33, a (1-4)-th connecting region SA34, a (1-5)-th connecting region SA35, and a (1-6)-th connecting region SA36.

The (1-1)-th connecting region SA31, which is adjacent to the central point CP, may have a rectangular shape. The (1-2)-th connecting region SA32, which is adjacent to a first side (for example, an upper side) of the (1-1)-th connecting region SA31, may have a rectangular shape. The (1-3)-th connecting region SA33, which is adjacent to a second side (for example, a right side) of the (1-1)-th connecting region SA31, may have a rectangular shape. The (1-4)-th connecting region SA34 is interposed between a boundary, which is between the first sub-region SA3 and the second region DP_NSA and a first side (for example, an upper side) of the (1-2)-th connecting region SA32. The (1-5)-th connecting region SA35 is interposed between the boundary, which is between the first sub-region SA3 and the second region DP_NSA and a first side (for example, an upper side) of the (1-3)-th connecting region SA33. The (1-6)-th connecting region SA36 is interposed between the boundary, which is between the first sub-region SA3 and the second region DP_NSA and a second side (for example, a right side) of the (1-3)-th connecting region SA33.

The second sub-region SA4 includes a (2-1)-th sub-region SA4a, a (2-2)-th sub-region SA4b, a (2-3)-th sub-region SA4c, and a (2-4)-th sub-region SA4d. The (2-1)-th sub-region SA4a and the (2-2)-th sub-region SA4b are disposed to be adjacent to the (1-1)-th sub-region SA3a, and the (1-2)-th sub-region SA3b. The (2-1)-th sub-region SA4a and the (2-2)-th sub-region SA4b have shapes symmetrical to shapes of the (1-1)-th sub-region SA3a and the (1-2)-th sub-region SA3b, respectively, about a first reference axis RX1 parallel to the vertical reference axis RX_V. The (2-3)-th sub-region SA4c and the (2-4)-th sub-region SA4d are disposed to be adjacent to the (1-3)-th sub-region SA3c, and the (1-4)-th sub-region SA3d. The (2-3)-th sub-region SA4c and the (2-4)-th sub-region SA4d have shapes symmetrical to shapes of the (1-3)-th sub-region SA3c and the (1-4)-th sub-region SA3d, respectively, about a second reference axis RX2 parallel to the vertical reference axis RX_V.

Each of the (2-1)-th to (2-4)-th sub-regions SA4a to SA4d may include a plurality of second connecting regions. Although FIG. 14 illustrates the structure including the (2-1)-th to (2-4)-th sub-regions SA4a to SA4d, each of which has sixth second connecting regions, the present invention is not limited thereto. The sixth second connecting regions may be referred to as a (2-1)-th connecting region SA41, a (2-2)-th connecting region SA42, a (2-3)-th connecting region SA43, a (2-4)-th connecting region SA44, a (2-5)-th connecting region SA45, and a (2-6)-th connecting region SA46.

The first connecting lines TCL1 may include a (1-1)-th connecting line TCL1a, a (1-2)-th connecting line TCL1b, and a (1-3)-th connecting line TCL1c, and the second connecting line TCL2 includes a (2-1)-th connecting line TCL2a, a (2-2)-th connecting line TCL2b, and a (2-3)-th connecting line TCL2c. The (1-1)-th connecting line TCL1a connects the (1-1)-th light emitting element, which is disposed in the (1-1)-th connecting region SA31, to the (1-1)-th pixel circuit disposed in the (2-1)-th connecting region SA41. The (1-2)-th connecting line TCL1b connects the (1-4)-th light emitting element, which is disposed in the (1-4)-th connecting region SA34, to the (1-4)-th pixel circuit disposed in the (2-4)-th connecting region SA44. The (1-3)-th connecting line TCL1c connects the (1-5)-th light emitting element disposed in the (1-5)-th connecting region SA35 to the (1-5)-th pixel circuit disposed in the (2-5)-th connecting region SA45. The (2-1)-th connecting line TCL2a connects the (1-2)-th light emitting element, which is disposed in the (1-2)-th connecting region SA32, to the (1-2)-th pixel circuit disposed in the (2-2)-th connecting region SA42. The (2-2)-th connecting line TCL2b connects the (1-3)-th light emitting element, which is disposed in the (1-3)-th connecting region SA33, to the (1-3)-th pixel circuit disposed in the (2-3)-th connecting region SA43. The (2-3)-th connecting line TCL2c connects the (1-6)-th light emitting element disposed in the (1-6)-th connecting region SA36 to the (1-6)-th pixel circuit disposed in the (2-6)-th connecting region SA46.

The (1-1)-th connecting line TCL1a may pass through the (1-3)-th connecting region SA33, the (1-6)-th connecting region SA36, the (2-6)-th connecting region SA46, and the (2-3)-th connecting region SA43, while extending from the (1-1)-th connecting region SA31 to the (2-1)-th connecting region SA41. The (1-2)-th connecting lines TCL1b may be arranged to be detoured to the second region DP_NSA. The (1-2)-th connecting lines TCL1b may extend from the (1-4)-th connecting region SA34 to the (2-4)-th connecting region SA44 to pass through the second region DP_NSA. The (1-3)-th connecting lines TCL1c may extend from the (1-5)-th connecting region SA35 to the (2-5)-th connecting region SA45 to pass through the second region DP_NSA.

The (2-1)-th connecting lines TCL2a may be arranged to be detoured to the second region DP_NSA. Specifically, the (2-1)-th connecting line TCL2a may extend from the (1-2)-th connecting region SA32 to the (2-2)-th connecting region SA42 to pass through the (1-4)-th connecting region SA34, the second region DP_NSA, and the (2-4)-th connecting region SA44. The (2-2)-th connecting lines TCL2b may be arranged to be detoured to the second region DP_NSA. Specifically, the (2-2)-th connecting lines TCL2b may extend from the (1-3)-th connecting region SA33 to the (2-3)-th connecting region SA43 to pass through the (1-5)-th connecting region SA35, the second region DP_NSA, and the (2-5)-th connecting region SA45. The (2-3)-th connecting lines TCL2c may extend from the (1-6)-th connecting region SA36 to the (2-6)-th connecting region SA46 to pass through the second region DP_NSA.

The (1-1)-th connecting line TCL1a, the (1-2)-th connecting line TCL1b, and the (1-3)-th connecting line TCL1c are disposed on a first layer, and the (2-1)-th connecting line TCL2a, the (2-2)-th connecting line TCL2b, and the (2-3)-th connecting line TCL2c are disposed on a second layer. In other words, the first connecting lines TCL1 and the second connecting lines TCL2 are disposed on layers that are different from each other.

As some of the connecting lines TCL1a to TCL1c, and TCL2a to TCL2c in the first region DP_SA are deposed to be detoured to the second region DP_NSA, the connecting lines TCL1a to TCL1c, and TCL2a to TCL2c disposed in the first region DP_SA may be disposed on two layers (that is, the first layer and the second layer). Accordingly, the connecting lines TCL1a to TCL1c, and TCL2a to TCL2c are efficiently arranged in the confined region to reduce the density of the connecting lines, so the layers may be prevented from being increased to prevent the thickness of the display panel DP from being increased, or to prevent the process mask from being added in manufacturing the display panel DP.

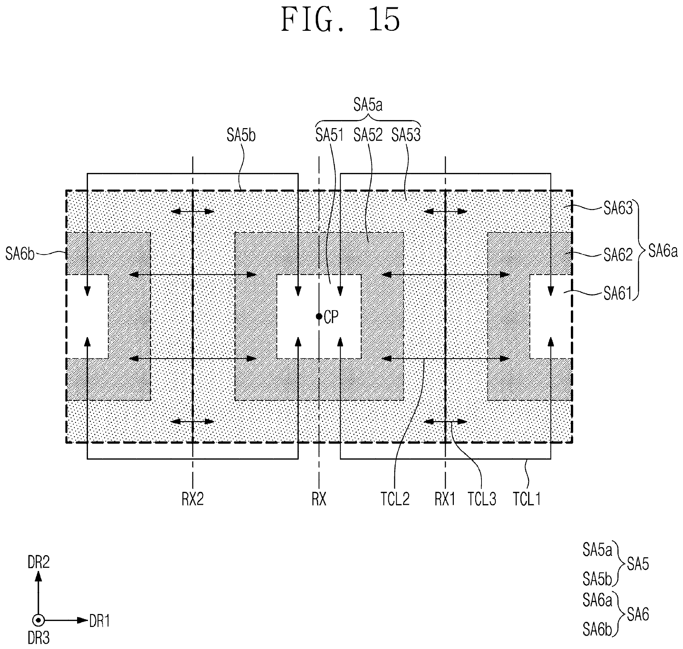

FIG. 15 is a view illustrating the shape of the first region and the arrangement structure of the connecting lines resulting from the shape according to one or more embodiments of the present invention.

Referring to FIG. 15, the first region DP_SA may include a first sub-region SA5 and a second sub-region SA6. According to one or more embodiments of the present invention, the first sub-region SA5 may have a rectangular shape (for example, a square shape). The first sub-region SA5 may be divided into two regions (that is, a (1-1)-th sub-region SA5a and a (1-2)-th sub-region SA5b) about a reference axis RX parallel to the second direction DR2 and passing through the central point CP. In other words, the (1-1)-th sub-region SA5a is disposed at a first side (for example, a right side) about the reference axis RX, and the (1-2)-th sub-region SA5b is disposed at a second side (for example, a left side) about the reference axis RX. Each of the (1-1)-th sub-region SA5a (or referred to as a "(1-1)-th rectangular region"), and the (1-2)-th sub-region SA5b (or referred to as a "(1-2)-th rectangular region") may have a rectangular shape. The (1-1)-th sub-region SA5a and the (1-2)-th sub-region SA5b may have shapes symmetrical to each other about the reference axis RX.

Each of the (1-1)-th sub-region SA5a and the (1-2)-th sub-region SA5b may include a plurality of first connecting regions. Although FIG. 15 illustrates the structure including the (1-1)-th sub-region SA5a and the (1-2)-th sub-region SA5b, each of which has three first connecting regions, the present invention is not limited thereto. The three first connecting regions may be referred to as a (1-1)-th connecting region SA51, a (1-2)-th connecting region SA52, and a (1-3)-th connecting region SA53, respectively. The (1-1)-th connecting region SA51 is adjacent to the center, and the (1-2)-th connecting region SA52 is disposed outside the (1-1)-th connecting region SA51. The (1-3)-th connecting region SA53 may be disposed to be adjacent to a boundary between the first and second sub-regions SA5 and SA6. According to one or more embodiments of the present invention, the (1-2)-th connecting region SA52 may be interposed between the (1-1)-th connecting region SA51 and the (1-3)-th connecting region SA53.

The second sub-region SA6 includes a (2-1)-th sub-region SA6a (or referred to as a "(2-1)-th rectangular region"), which is adjacent to the (1-1)-th sub-region SA5a, and a (2-2)-th sub-region SA6b (or referred to as a "(2-2)-th rectangular region") adjacent to the (1-2)-th sub-region SA5b. In other words, the (2-1)-th sub-region SA6a is interposed between the (1-1)-th sub-region SA5a and the second region DP_NSA, and the (2-2)-th sub-region SA6b is interposed between the (1-2)-th sub-region SA5b and the second region DP_NSA. The (2-1)-th sub-region SA6a may have a shape symmetrical to a shape of the (1-1)-th sub region SA5a about a first reference axis RX1 parallel to the reference axis RX. The (2-2)-th sub-region SA6b may have a shape symmetrical to a shape of the (1-2)-th sub-region SA5b about a second reference axis RX2 parallel to the reference axis RX.

Each of the (2-1)-th sub-region SA6a and the (2-2)-th sub-region SA6b may include a plurality of second connecting regions. Although FIG. 15 illustrates the structure including the (2-1)-th sub-region SA6a and the (2-2)-th sub-region SA6b, each of which has three second connecting regions, the present invention is not limited thereto. The three second connecting regions may be referred to as a (2-1)-th connecting region SA61, a (2-2)-th connecting region SA62, and a (2-3)-th connecting region SA63, respectively. According to one or more embodiments of the present invention, the (2-2)-th connecting region SA62 is disposed to be more adjacent (or closer) to the first sub-region SA5, rather than the (2-1)-th connecting region SA61, and the (2-3)-th connecting region SA63 is disposed to be more adjacent (or closer) to the first sub-region SA5, rather than the (2-2)-th connecting region SA62.

The connecting line TCL may include a plurality of connecting lines. The connecting lines may include the first connecting lines TCL1, the second connecting lines TCL2, and the third connecting lines TCL3. The first connecting lines TCL1 connect the (1-1)-th light emitting elements disposed in the (1-1)-th connecting region SA51 to the (1-1)-th pixel circuits disposed in the (2-1)-th connecting region SA61. The second connecting lines TCL2 connect the (1-2)-th light emitting elements disposed in the (1-2)-th connecting region SA52 to the (1-2)-th pixel circuit disposed in the (2-2)-th connecting region SA62. The third connecting lines TCL3 connect the (1-3)-th light emitting elements disposed in the (1-3)-th connecting region SA53 to the (1-3)-th pixel circuit disposed in the (2-3)-th connecting region SA63.

The length of the first connecting lines TCL1 is longer than the length of the second connecting lines TCL2, and the length of the second connecting lines TCL2 is longer than the length of the third connecting lines TCL3. The line resistance of the first connecting lines TCL1 may be equal to or different from the line resistance of the second connecting lines TCL2. The thickness and the width of the first connecting lines TCL1 are adjusted, such that the line resistance of the first connecting lines TCL1 may be equal to the line resistance of the second connecting lines TCL2.

According to one or more embodiments of the present invention, the first connecting lines TCL1 have lengths equal to each other, and the second connecting lines TCL2 have lengths equal to each other. Accordingly, the first connecting lines TCL1 have line resistances equal to each other, and the second connecting lines TCL2 have line resistances equal to each other. In addition, as the third connecting lines TCL3 have lengths equal to each other, the third connecting lines TCL3 may have line resistances equal to each other.

The first connecting lines TCL1 may extend from the (1-1)-th connecting region SA51 to the (2-1)-th connecting region SA61. The first connecting lines TCL1 may be arranged to be detoured to the second region DP_NSA. Some of the first connecting lines TCL1 may be partially overlapped with the second region DP_NSA. The second connecting lines TCL2 may extend from the (1-2)-th connecting region SA52 to the (2-2)-th connecting region SA62. The second connecting lines TCL2 may be partially overlapped with the (1-3)-th and (2-3)-th connecting region SA53 and SA63. The third connecting lines TCL3 may extend from the (1-3)-th connecting region SA53 to the (2-3)-th connecting region SA63.

According to one or more embodiments of the present invention, the first connecting lines TCL1 are disposed on a first layer, the second connecting lines TCL2 are disposed on a second layer, and the third connecting lines TCL3 are disposed on the first layer or the second layer. In other words, the first connecting lines TCL1 and the second connecting lines TCL2 may be disposed on layers different from each other, and the third connecting lines TCL3 may be disposed on a layer that is the same as the layer of the first connecting lines TCL1, or disposed on a layer that is the same as the layer of the second connecting lines TCL2.

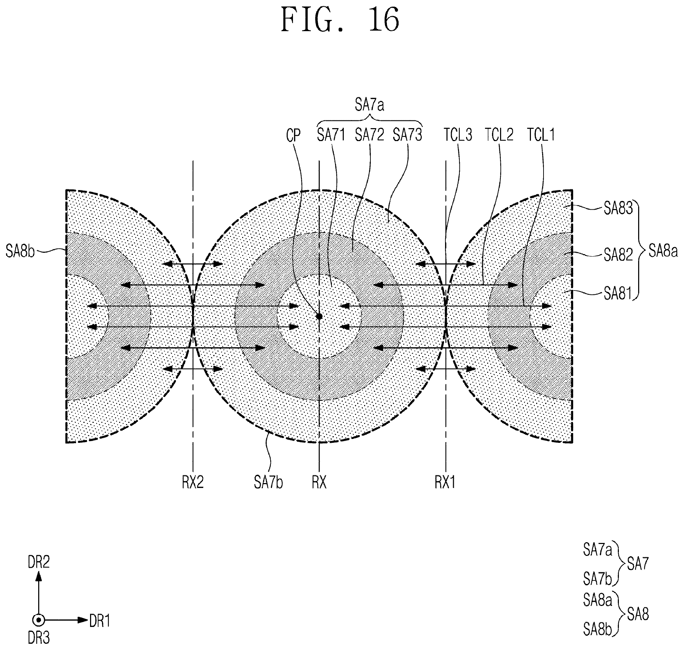

FIG. 16 is a view illustrating the shape of the first region and the arrangement structure of the connecting lines resulting from the shape according to one or more embodiments of the present invention.

Referring to FIG. 16, the first region DP_SA may include a first sub-region SA7 and a second sub-region SA8. According to one or more embodiments of the present invention, the first sub-region SA7 may have a circular shape. The first sub-region SA7 may be divided into two regions (that is, a (1-1)-th sub-region SA7a and a (1-2)-th sub-region SA7b) about a reference axis RX, which is parallel to the second direction DR2 and passes through the central point CP. In other words, the (1-1)-th sub-region SA7a is disposed at a first side (for example, a right side) about the reference axis RX, and the (1-2)-th sub-region SA7b is disposed at a second side (for example, a left side) about the reference axis RX. Each of the (1-1)-th sub-region SA7a (or referred to as a (1-1)-th semi-circular region) and the (1-2)-th sub-region SA7b (or referred to as a (1-2)-th semi-circular region) may have a semi-circular shape. The (1-1)-th sub-region SA7a and the (1-2)-th sub-region SA7b may have shapes symmetrical to each other about the reference axis RX.

Each of the (1-1)-th sub-region SA7a and the (1-2)-th sub-region SA7b may include a plurality of first connecting regions. Although FIG. 16 illustrates the structure including the (1-1)-th sub-region SA7a and the (1-2)-th sub-region SA7b, each of which has three first connecting regions, the present invention is not limited thereto. The three first connecting regions may be referred to as a (1-1)-th connecting region SA71, a (1-2)-th connecting region SA72, and a (1-3)-th connecting region SA73, respectively. The (1-1)-th connecting region SA71 is adjacent to the center, and the (1-2)-th connecting region SA72 is disposed to be around (e.g., to surround) the (1-1)-th connecting region SA71. The (1-3)-th connecting region SA73 is disposed to be around (e.g., to surround) the (1-2)-th connecting region SA72. According to one or more embodiments of the present invention, the (1-2)-th connecting region SA72 may be interposed between the (1-1)-th connecting region SA71 and the (1-3)-th connecting region SA73.

The second sub-region SA8 includes a (2-1)-th sub-region SA8a (or referred to as a "(2-1)-th semi-circular region"), which is adjacent to the (1-1)-th sub-region SA7a, and a (2-2)-th sub-region SA8b (or referred to as a "(2-2)-th semi-circular region") adjacent to the (1-2)-th sub-region SA7b. In other words, the (2-1)-th sub-region SA8a may have a shape symmetrical to a shape of the (1-1)-th sub region SA7a about a first reference axis RX1 parallel to the reference axis RX. The (2-2)-th sub-region SA8b may have a shape symmetrical to a shape of the (1-2)-th sub region SA7b about a second reference axis RX2 parallel to the reference axis RX.

Although the structure including the (2-1)-th sub-region SA8a and the (2-2)-th sub-region SA8b, each of which has three second connecting regions is illustrated, the present invention is not limited thereto. The three second connecting regions may be referred to as a (2-1)-th connecting region SA81, a (2-2)-th connecting region SA82, and a (2-3)-th connecting region SA83, respectively.

The connecting line TCL may include a plurality of connecting lines. The connecting lines may include the first connecting lines TCL1, the second connecting lines TCL2, and the third connecting lines TCL3. The first connecting lines TCL1 connect the (1-1)-th light emitting elements disposed in the (1-1)-th connecting region SA71 to the (1-1)-th pixel circuits disposed in the (2-1)-th connecting region SA81. The second connecting lines TCL2 connect the (1-2)-th light emitting elements, which are disposed in the (1-2)-th connecting region SA72, to the (1-2)-th pixel circuit disposed in the (2-2)-th connecting region SA82. The third connecting lines TCL3 connect the (1-3)-th light emitting elements, which are disposed in the (1-3)-th connecting region SA73, to the (1-3)-th pixel circuit disposed in the (2-3)-th connecting region SA83.

According to one or more embodiments of the present invention, the first connecting lines TCL1 are disposed on a first layer, the second connecting lines TCL2 are disposed on a second layer, and the third connecting lines TCL3 are disposed on the first layer or the second layer. In other words, the first connecting lines TCL1 and the second connecting lines TCL2 may be disposed on layers that are different from each other, and the third connecting lines TCL3 may be disposed on a layer that is the same as the layer of the first connecting lines TCL1, or disposed on a layer that is the same as the layer of the second connecting lines TCL2.

As described above, some of connecting lines in the first region are arranged to be detoured to the second region, such that the connecting lines disposed in the first region may be provided on two layers (that is, the first layer and the second layer). Accordingly, the connecting lines are efficiently arranged in the confined region to reduce the density of the connecting lines, so the layers may be prevented from being increased to prevent the thickness of the display panel from being increased, or to prevent the process mask from being added in manufacturing the display panel. Accordingly, the manufacturing process of the display panel may be simplified, so the productivity is improved.

In addition, the density of the connecting lines disposed in the first region may be reduced. Accordingly, the transmittance of the first region may be improved, thereby improving the performance of the electronic module to making optical communication through the first region.

While the present invention has been described with reference to embodiments thereof, it will be apparent to those of ordinary skill in the art that various changes and modifications may be made thereto without departing from the scope of the present invention as set forth in the following claims.

## Claims

1. An electronic device (1000) comprising:
a display panel (DP) including a first region (DP_SA) and a second region (DP_NSA) adjacent to the first region (DP_SA),
wherein the first region (DP_SA) includes:
a first sub-region (SA1, SA3, SA5, SA7); and
a second sub-region (SA2, SA4. SA6, SA8) having light transmittance lower than light transmittance of the first sub-region (SA1, SA3, SA5, SA7); and
an electronic module (CM) under the display panel (DP) corresponding to the first region (DP_SA),
wherein the display panel (DP) comprises:
first light emitting elements (ED1) in the first sub-region (SA1, SA3, SA5, SA7);
first pixel circuits (PC1) connected to the first light emitting elements (ED1), and located in the second sub-region (SA2, SA4. SA6, SA8);
second light emitting elements (ED2) in the second sub-region (SA2, SA4. SA6, SA8);
second pixel circuits (PC2) connected to the second light emitting elements (ED2), and located in the second sub-region (SA2, SA4. SA6, SA8); and
connecting lines (TCL) connecting the first light emitting elements (ED1) to the first pixel circuits (PC1),
wherein the connecting lines (TCL) comprise:
first connecting lines (TCL1) on a first layer; and
second connecting lines (TCL2) on a second layer covering the first connecting lines (TCL1), and
wherein the first connecting lines (TCL1) have a length different from a length of the second connecting lines (TCL2).

2. The electronic device (1000) of claim 1, wherein the first sub-region (SA1) includes:
a (1-1)-th connecting region (SA11) adjacent to a center of the first sub-region (SA1), (1-1)-th light emitting elements (ED11) being located in the (1-1)-th connecting region (SA11); and
a (1-2)-th connecting region (SA12) outside the (1-1)-th connecting region (SA11), (1-2)-th light emitting elements (ED12) being located in the (1-2)-th connecting region (SA12),
wherein the second sub-region (SA2) includes:
a (2-1)-th connecting region (SA21) on which (1-1)-th pixel circuits (PC11) connected to the (1-1)-th light emitting elements (ED11) are located; and
a (2-2)-th connecting region (SA22) on which (1-2)-th pixel circuits (PC12) connected to the (1-2)-th light emitting elements (ED12) are located, and
wherein the (2-2)-th connecting region (SA22) is more adjacent to the first sub-region (SA1) than the (2-1)-th connecting region (SA21).

3. The electronic device (1000) of claim 2, wherein the first connecting lines (TCL1) connect the (1-1)-th light emitting elements (ED11) to the (1-1)-th pixel circuits (PC11);
wherein the second connecting lines (TCL2) connect the (1-2)-th light emitting elements (ED12) to the (1-2)-th pixel circuits (PC12); and
wherein a length of the first connecting lines (TCL1) is greater than a length of the second connecting lines (TCL2).

4. The electronic device (1000) of at least one of claims 1 to 3, wherein the first connecting lines (TCL1) are partially overlapped with the second region (DP_NSA).

5. The electronic device (1000) of at least one of claims 2 to 4, wherein the first sub-region (SA1) further includes:
a (1-3)-th connecting region (SA13) adjacent to a boundary between the first sub-region (SA1) and the second sub-region (SA2), (1-3)-th light emitting elements (ED13) being located in the (1-3)-th connecting region (SA13),
wherein the second sub-region (SA2) further comprises:
a (2-3)-th connecting region (SA23) on which (1-3)-th pixel circuits (PC13) connected to the (1-3)-th light emitting elements (ED13) are located, and
wherein the (2-3)-th connecting region (SA23) is interposed between the (1-3)-th connecting region (SA13) and the (2-2)-th connecting region (SA22).

6. The electronic device (1000) of claim 5, wherein the first connecting lines (TCL1) connect the (1-1)-th light emitting elements (ED11) to the (1-1)-th pixel circuits (PC11),
wherein the second connecting lines (TCL2) connect the (1-2)-th light emitting elements (ED12) to the (1-2)-th pixel circuits (PC12),
wherein the connecting lines (TCL) further comprise:
third connecting lines (TCL3) connecting the (1-3)-th light emitting elements (ED13) to the (1-3)-th pixel circuits (PC13), and
wherein the third connecting lines (TCL3) are on the first layer or the second layer.

7. The electronic device (1000) of claim 6, wherein the first connecting lines (TCL1) have a length longer than a length of the second connecting lines (TCL2), and
wherein the third connecting lines (TCL3) have a length shorter than the length of the second connecting lines (TCL2).

8. The electronic device (1000) of at least one of claims 5 to 7, wherein the second connecting lines (TCL2) overlap with the (1-2)-th connecting region (SA12), the (1-3)-th connecting region (SA13), the (2-3)-th connecting region (SA23), and the (2-2)-th connecting region (SA22).

9. The electronic device (1000) of at least one of claims 6 to 8, wherein the first connecting lines (TCL1) have lengths equal to each other.
wherein the second connecting lines (TCL2) have lengths equal to each other, and
wherein the third connecting lines (TCL3) have lengths equal to each other.

10. The electronic device (1000) of at least one of claims 6 to 9, wherein a line resistance of the first connecting lines (TCL1) is equal to a line resistance of the second connecting lines (TCL2) and a line resistance of the third connecting lines (TCL3).

11. The electronic device (1000) of claim 1, wherein the first sub-region (SA7) includes:
a (1-1)-th sub-region (SA7a) at a first side with respect to a reference axis (RX); and
a (1-2)-th sub-region (SA7b) at a second side with respect to the reference axis (RX), and
wherein the second sub-region (SA8) includes:
a (2-1)-th sub-region (SA8a) adjacent to the (1-1)-th sub-region (SA7a), and symmetrical to the (1-1)-th sub-region (SA7a) with respect to a first reference axis (RX1); and
a (2-2)-th sub-region (SA8b) adjacent to the (1-2)-th sub-region (SA7b), and symmetrical to the (1-2)-th sub-region (SA7b) with respect to a second reference axis (RX2).

12. The electronic device (1000) of claim 11, wherein the (1-1)-th sub-region (SA7a) includes:
a (1-1)-th connecting region (SA71) adjacent to a center of the first sub-region (SA7), (1-1)-th light emitting elements (ED11) being located in the (1-1)-th connecting region (SA71); and
a (1-2)-th connecting region (SA72) outside the (1-1)-th connecting-region (SA7a), (1-2)-th light emitting elements (ED12) being located in the (1-2)-th connecting region (SA72), and
wherein the (2-1)-th sub-region (SA7b) includes:
a (2-1)-th connecting region (SA81) symmetrical to the (1-1)-th connecting region (SA71) with respect to the first reference axis (RX1), and comprising (1-1)-th pixel circuits (PC11) connected to the (1-1)-th light emitting elements (ED11), and
a (2-2)-th connecting region (SA82) symmetrical to the (1-2)-th connecting region (SA72) with respect to the first reference axis (RX1), and comprising (1-2)-th pixel circuits (PC12) connected to the (1-2)-th light emitting elements (ED12).

13. The electronic device (1000) of claim 1, 11 or 12, wherein the first sub-region (SA7) has a circular shape based on a central point (CP), and including a (1-1)-th semi-circular region (SA71), and a (1-2)-th semi-circular region (SA72) that are defined based on the central point (CP), and
wherein the second sub-region (SA8) includes:
a (2-1)-th semi-circular region (SA81) adjacent to the (1-1)-th semi-circular region (SA71) and a (2-2)-th semi-circular region (SA82) adjacent to the (1-2)-th semi-circular region (SA72).

14. The electronic device (1000) of at least one of claims 1 to 13, wherein the first sub-region (SA1, SA3, SA7) has a circular shape based on a central point (CP), and
wherein the second sub-region (SA2, SA4, SA8) corresponds to a remaining region of the first region (DP_SA) except for the first sub-region (SA1, SA3, SA7).

15. The electronic device (1000) of claim 1, wherein the first sub-region (SA5) has a rectangular shape based on a central point (CP), and including a (1-1)-th rectangular region (SA5a), and a (1-2)-th rectangular region (SA5b) defined based on the central point (CP), and
wherein the second sub-region (SA6) includes:
a (2-1)-th rectangular region (SAa) adjacent to the (1-1)-th rectangular region (SA5a); and
a (2-2)-th rectangular region (SA6b) adjacent to the (1-2)-th rectangular region (SA5b).

16. An electronic device (1000) comprising:
a display panel (DP) including a first region (DP_SA) and a second region (DP_NSA) adjacent to the first region (DP_SA),
wherein the first region (DP_SA) includes:
a first sub-region (SA1, SA3, SA5, SA7); and
a second sub-region (SA2, SA4. SA6, SA8) having light transmittance lower than light transmittance of the first sub-region (SA1, SA3, SA5, SA7); and
an electronic module (CM) under the display panel (DP) corresponding to the first region (DP_SA),
wherein the display panel (DP) comprises:
first light emitting elements (ED1) in the first sub-region (SA1, SA3, SA5, SA7);
first pixel circuits (PC1) connected to the first light emitting elements (ED1), and located in the second sub-region (SA2, SA4. SA6, SA8);
second light emitting elements (ED2) in the second sub-region (SA2, SA4. SA6, SA8);
second pixel circuits (PC2) connected to the second light emitting elements (ED2), and located in the second sub-region (SA2, SA4. SA6, SA8); and
connecting lines (TCL) connecting the first light emitting elements (ED1) to the first pixel circuits (PC1), and
wherein the connecting lines (TCL) comprise:
first connecting lines (TCL1) extending from the second sub-region (SA2, SA4. SA6, SA8) to the first sub-region (SA1, SA3, SA5, SA7); and
second connecting lines (TCL2) extending from the second sub-region (SA2, SA4. SA6, SA8) to the first sub-region (SA1, SA3, SA5, SA7) through the second region (DP_NSA).

17. The electronic device (1000) of at least one of claims 1 to 16, wherein the first connecting lines (TCL1) have equal lengths, and
wherein the second connecting lines (TCL2) have equal lengths.

18. The electronic device (1000) of at least one of claims 1 to 17, wherein a line resistance of the first connecting lines (TCL1) is substantially equal to a line resistance of the second connecting lines (TCL2).

19. The electronic device (1000) of at least one of claims 1 to 18, wherein a width of the first connecting lines (TCL1) is different from a width of the second connecting lines (TCL2).

20. The electronic device (1000) of at least one of claims 1 to 19, wherein a thickness of the first connecting lines (TCL1) is different from a thickness of the second connecting lines (TCL2).
